Europäisches Patentamt

European Patent Office

Office européen des brevets

(19)

(11) **EP 0 504 063 B1**

(12) **FASCICULE DE BREVET EUROPEEN**

| | |
|---|---|
| (45) Date de publication et mention de la délivrance du brevet: **25.06.1997 Bulletin 1997/26** | (51) Int Cl.⁶: **H04L 5/14**, H04B 1/58 |

(21) Numéro de dépôt: **92400662.0**

(22) Date de dépôt: **12.03.1992**

(54) **Emetteur-récepteur pour la transmission bidirectionelle simultanée de données en bande de base**

Sender-Empfänger für gleichzeitige, bidirektionelle Datenübertragung im Basisband

Transceiver for the simultaneous bidirectional baseband transmission of data

| | |
|---|---|
| (84) Etats contractants désignés: **AT BE CH DE ES FR GB IT LI NL SE** | (72) Inventeur: **Marbot, Roland** **F-75116 Paris (FR)** |
| (30) Priorité: **14.03.1991 FR 9103127** | (74) Mandataire: **Colombe, Michel et al** **Direction de la Propriété Intellectuelle BULL SA** **Poste courrier:LV 59C18** **68 route de Versailles** **78430 Louveciennes (FR)** |
| (43) Date de publication de la demande: **16.09.1992 Bulletin 1992/38** | |
| (73) Titulaire: **BULL S.A.** **78430 Louveciennes (FR)** | (56) Documents cités: **EP-A- 0 220 626** US-A- 3 700 831 **US-A- 3 909 559** |

## Description

L'invention concerne les transmissions de données numériques entre stations ou unités par l'intermédiaire de liaisons série bidirectionnelles de type point à point. Ces liaisons comportent un support de transmission, tel que paires torsadées, câbles coaxiaux ou fibres optiques, relié à chaque extrémité à une station par un émetteur et un récepteur associé à la station.

Pour de nombreuses applications, on préfère utiliser un mode de transmission permettant un fonctionnement simultané dans les deux sens entre les deux points afin d'obtenir une meilleure utilisation des lignes.

En particulier, cette solution sera adaptée pour réaliser l'interconnexion entre les unités d'un sous-système central informatique comportant un grand nombre d'unités. En effet, la tendance actuelle étant d'augmenter considérablement le nombre de processeurs et de mémoires, le choix d'un bus pour effectuer les échanges d'informations entre toutes ces unités n'est plus adapté. Il est préférable dans ce contexte d'utiliser des liaisons série reliant chaque unité à toutes les autres unités du système de façon à augmenter le parallélisme. Compte tenu du grand nombre de liaisons impliquées dans un tel système, le choix de liaisons bidirectionnelles est préférable.

De façon générale, une transmission bidirectionnelle nécessite au niveau de chaque station la présence d'un émetteur-récepteur relié aux lignes par une impédance d'adaptation. Il faut en outre prévoir dans la partie réceptrice des moyens permettant de traiter les collisions, c'est-à-dire les cas où les émetteurs des deux stations reliées entre elles émettent simultanément sur la liaison commune. Ces moyens doivent permettre en toute circonstance de détecter à partir de l'état électrique de la ligne l'existence et la nature des signaux émis par la station éloignée.

Pour résoudre ce problème, on utilise habituellement le principe d'une compensation dans le récepteur de l'effet produit sur la ligne par l'émetteur de la même station lorsque celui-ci émet. Ceci revient à effectuer en cas d'émission une soustraction du signal d'émission au signal présent sur la ligne. La différence obtenue est alors représentative du signal émis par l'émetteur de la station éloignée. Une telle solution est décrite dans la demande de brevet européen EP-A-186 142 intitulée "Two wire bidirectional digital transmission system".

Le document EP-A-0220 626 décrit un émetteur-récepteur pour liaison de transmission bidirectionnelle, muni d'une impédance d'adaptation R11. L'émetteur-récepteur comprend un amplificateur différentiel (R2, R3, T1, T2, T4, R6) pour effectuer la différence entre un signal SGN1, représentatif du signal présent sur la liaison, et un signal SEN1, représentatif du signal de commande d'émission DATA SIGNAL 1.

Le document US-A-3909 559 décrit un émetteur-récepteur pour liaison de transmission bidirectionnelle à deux conducteurs dont l'un est mis à la masse. Selon les figures 3 et 4 de ce document, il semblerait possible de connecter plusieurs émetteurs-récepteurs identiques sur une même liaison à condition de brancher au moins une impédance d'adaptation entre les deux conducteurs, à l'extérieur des émetteurs-récepteurs.

L'invention propose une autre solution consistant non pas à soustraire du signal de ligne le signal d'émission lorsque l'émetteur de la station considérée émet mais au contraire à additionner, lorsque la station n'émet pas, le signal de ligne à un signal de compensation de même polarité convenablement choisi pour que la somme en résultant soit représentative du signal d'émission de l'autre station.

Plus précisément l'invention a pour objet un émetteur-récepteur prévu pour être relié par une liaison de transmission à un autre émetteur-récepteur analogue, ladite liaison comportant au moins une ligne de transmission, ledit émetteur-récepteur comportant des moyens d'amplification pour produire des signaux d'émission sur ladite liaison en réponse à des signaux de commande d'émission et pour produire des signaux de réception en réponse aux signaux d'émission produits sur ladite liaison par l'autre émetteur-récepteur, ledit émetteur-récepteur étant caractérisé en ce que lesdits moyens d'amplification comportent pour chaque ligne de transmission un amplificateur bidirectionnel 1 comprenant:

- une première impédance d'adaptation à la ligne et connectée à celle-ci,
- un premier générateur commandé en réponse auxdits signaux de commande d'émission et alimentant en parallèle ladite première impédance et ladite ligne,
- des moyens de détection, commandés en réponse auxdits signaux de commande d'émission, pour fournir un signal de mesure qui est représentatif soit du courant circulant dans l'impédance d'adaptation lorsque ledit premier générateur est actif, soit de la somme du courant circulant dans l'impédance d'adaptation et d'une valeur de compensation lorsque ledit premier générateur n'est pas actif,

ladite valeur de compensation étant déterminée de façon à satisfaire à une condition de compensation selon laquelle ledit signal de mesure ne dépend pratiquement que des signaux d'émission produits par l'autre émetteur-récepteur.

De multiples réalisations sont envisageables pour produire un signal représentatif de la somme de deux courants. Néanmoins, l'invention présente l'avantage qu'elle permet de choisir des réalisations particulièrement simples car les circuits pour additionner deux signaux de même polarité peuvent être plus simples que ceux qui effectuent les différences.

Cet avantage est particulièrement appréciable si l'on cherche à obtenir un fonctionnement à très haute fréquence car la complexité des circuits entraîne toujours des perturbations dues notamment aux liaisons électriques et aux connexions.

Aussi, l'invention concerne également une réalisation simple et efficace où l'émetteur-récepteur est en outre caractérisé en ce que lesdits moyens de détection comportent une seconde impédance dont une première borne est reliée à un point commun à l'impédance d'adaptation et à la ligne, dont la seconde borne, appelée borne de réception, est alimentée en courant par un second générateur commandé en réponse aux signaux de commande d'émission et de même polarité que ledit premier générateur, en ce que lesdits premier et second générateurs sont commandés en réponse auxdits signaux de commande de façon à ce que le premier générateur soit actif alors que le second générateur ne l'est pas et réciproquement, et en ce que ledit signal de mesure est la tension présente sur ladite borne de réception, ladite valeur de compensation étant la tension aux bornes de ladite seconde impédance, lesdits générateurs et ladite seconde impédance étant dimensionnés de façon à satisfaire ladite condition de compensation.

La condition de compensation mentionnée ci-dessus impose, comme nous le verrons en détail ultérieurement, une relation entre les valeurs des impédances et des courants impliqués dans l'amplificateur bidirectionnel. Dans le cas d'une réalisation au moyen de circuits discrets, il serait possible de vérifier cette relation par un simple dimensionnement des composants de l'amplificateur bidirectionnel. Par contre, cette solution est difficilement applicable dans le cas d'un circuit intégré à cause des dispersions de fabrication ainsi que des dérives des caractéristiques par vieillissement ou variations de température.

Pour résoudre ce problème, et selon une caractéristique particulière de l'invention, l'émetteur-récepteur est caractérisé en ce que ledit premier générateur comporte une source de courant réglable et commandée par des premiers moyens d'asservissement tels que ladite condition de compensation soit satisfaite.

D'autre part, pour réaliser un émetteur-récepteur intégré capable de fonctionner à haut débit, par exemple de l'ordre de 1 Gbit/s, la solution consistant à utiliser une impédance d'adaptation externe au circuit intégré entraîne des difficultés dues notamment aux inductances parasites introduites par les connexions entre l'impédance et les bornes du circuit intégré. Ce problème peut être résolu si l'impédance d'adaptation est elle-même intégrée mais on retrouve les problèmes précédents dûs aux dispersions de fabrication et aux dérives des caractéristiques.

Pour résoudre ce dernier problème et selon un autre aspect de l'invention, l'émetteur-récepteur est caractérisé en ce qu'il fait partie d'un circuit intégré et en ce que la première impédance est réglable et commandée par des seconds moyens d'asservissement tels que ladite première impédance prenne une valeur égale à celle d'une impédance calibrée extérieure au circuit intégré et ayant la valeur de l'impédance caractéristique de la ligne.

D'autres caractéristiques de l'émetteur-récepteur selon l'invention apparaîtront dans la suite de la description.

En particulier, l'invention concerne également un émetteur-récepteur de type différentiel destiné à être relié à une liaison différentielle formée de deux lignes servant à véhiculer en fonctionnement normal des tensions complémentaires représentatives d'une valeur logique binaire correspondante. Cette réalisation présente les avantages notamment de diminuer le bruit et de simplifier le récepteur par l'utilisation de comparateurs auto-référencés.

Aussi, l'invention a également pour objet un émetteur-récepteur caractérisé en ce que, ladite liaison comprenant deux lignes de transmission, lesdits moyens d'amplification comportent deux voies formées de deux amplificateurs bidirectionnels associés respectivement auxdites lignes de transmission, en ce que lesdits amplificateurs sont commandés respectivement par deux signaux différentiels d'émission formant lesdits signaux de commande d'émission, en ce que l'un des signaux différentiels commande le premier générateur de courant du premier amplificateur ainsi que le second générateur de courant du second amplificateur, l'autre desdits signaux différentiels commande le premier générateur du second amplificateur ainsi que le second générateur du premier amplificateur et en ce que lesdits signaux de réception sont fonction de la tension différentielle présente entre les bornes de réception des deux amplificateurs bidirectionnels.

L'invention concerne également un circuit intégré incorporant une pluralité d'émetteurs-récepteurs ayant les caractéristiques mentionnées ci-dessus. Dans ce cas, certains éléments tels que les moyens d'asservissement pourront être communs à plusieurs émetteurs-récepteurs du même circuit intégré.

L'invention concerne enfin un système informatique dans lequel l'interconnexion entre les unités fonctionnelles de ce système est réalisée au moyen de circuits intégrés conformes à l'invention et associés respectivement aux unités de ce système.

D'autres aspects, détails de réalisation et avantages de l'émetteur-récepteur selon l'invention seront également exposés dans la description qui va suivre.

- La figure 1 représente un amplificateur bidirectionnel utilisé dans l'émetteur-récepteur selon l'invention.

- La figure 2 représente les moyens d'asservissement associés à l'amplificateur bidirectionnel.

- La figure 3 représente un amplificateur bidirectionnel de type différentiel.

- La figure 4 représente une réalisation des premiers moyens d'asservissement.

- La figure 5 représente la partie réception des moyens d'amplification de l'émetteur-récepteur selon l'invention.

- La figure 6 représente des seconds moyens d'asservissement.

- La figure 7 représente un mode de réalisation d'une impédance d'adaptation réglable.

- La figure 8 représente des circuits permettant de réaliser les seconds moyens d'asservissement.

- La figure 9 représente un circuit d'interface parallèle-série, série-parallèle utilisant l'émetteur-récepteur selon l'invention.

- Les figures 10, 11 et 12 illustrent les procédés de test applicables aux émetteurs-récepteurs et aux circuits intégrés selon l'invention.

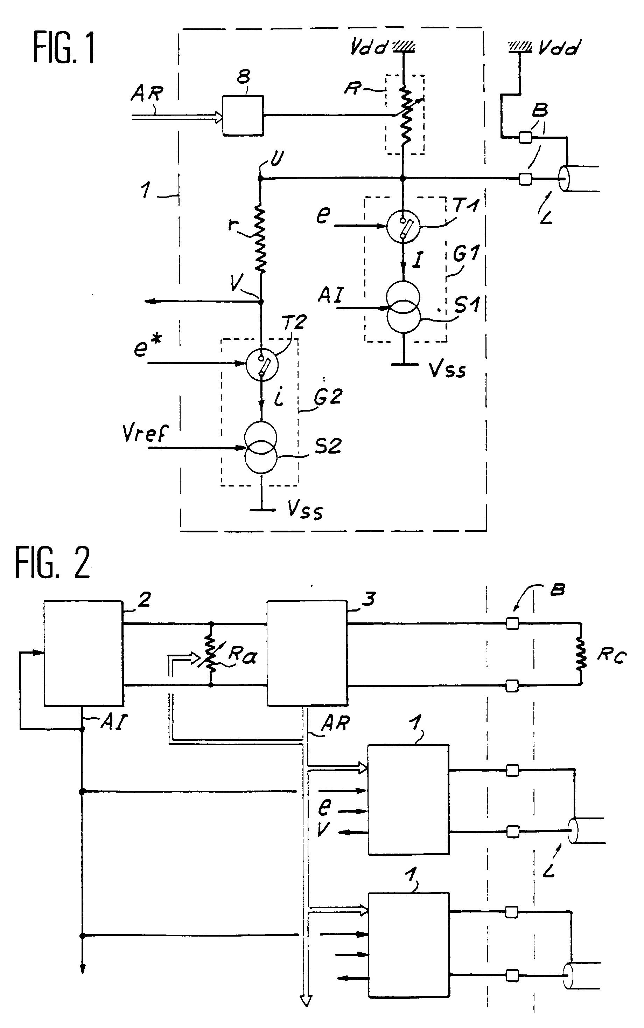

La figure 1 est une représentation fonctionnelle simplifiée de l'amplificateur bidirectionnel utilisé dans l'émetteur-récepteur.

L'amplificateur 1 comprend une impédance d'adaptation R reliée à la ligne L par des bornes B ainsi qu'un premier générateur de courant G1 commandé par un signal de commande d'émission e. Le générateur G1 est branché en parallèle avec un montage comportant une seconde impédance r branchée en série avec un second générateur de courant G2 de même polarité que le générateur G1 et commandé par le signal e* complément de e. La borne V de l'impédance r qui est reliée au générateur de courant G2 constitue la borne de réception dont la tension est représentative du signal émis par l'autre station reliée à l'autre extrémité de la ligne L. L'autre borne U de l'impédance r est reliée au point commun à l'impédance R, au générateur G1 et à la ligne L. L'autre borne de l'impédance R est reliée à un potentiel fixe Vdd supposé être la masse du circuit. Dans le cas où la ligne est un câble coaxial, comme représenté, le blindage du câble est relié à la masse.

Le premier générateur de courant G1 est constitué d'une première source de courant S1 fournissant un courant I d'intensité variable en fonction d'un signal de réglage AI. La source de courant S1 est reliée à l'impédance R par l'intermédiaire d'un interrupteur T1 commandé par le signal e.

De façon analogue, le second générateur G2 comporte une seconde source de courant S2 fournissant un courant i réglé en fonction d'une tension de référence Vref et reliée à l'impédance r par l'intermédiaire d'un second interrupteur T2 commandé par le signal e*.

Les sources de courant S1, S2 sont alimentées par un second potentiel fixe Vss négatif par rapport à la masse. L'impédance R est supposée variable en fonction de signaux de réglage AR par l'intermédiaire d'un décodeur 8.

Pour simplifier les explications du principe de fonctionnement de l'amplificateur bidirectionnel, nous supposerons tout d'abord que la ligne L est sans perte, que i est négligeable par rapport à I et que la valeur de l'impédance R est très petite par rapport à celle de r. D'autre part, nous supposerons qu'un amplificateur bidirectionnel de même constitution d'une station éloignée est connecté à l'autre extrémité de la ligne L. Enfin, nous supposerons que l'état d'émission d'une station se traduit par la mise à 1 logique du signal de commande d'émission e qui, dans ce cas, provoque la fermeture de l'interrupteur T1 et l'ouverture de l'interrupteur T2.

En fonctionnement, quatre situations peuvent se présenter:

a) La station considérée est seule à émettre. Le générateur G2 est alors inactif tandis que le générateur G1 fournit un courant I à l'impédance R en parallèle avec l'impédance caractéristique de la ligne L. L'impédance R étant supposée adaptée à la ligne, un courant I/2 circule dans cette impédance et la tension présente à la borne U ainsi qu'à la borne V est égale à - R.I/2.

b) Si aucune station n'émet, le générateur G1 de chaque station est inactif, les générateurs G2 sont actifs. La tension à la borne V est alors pratiquement égale à - r.i.

c) Si les deux stations émettent, les générateurs G2 sont inactifs et le courant I produit par le premier générateur G1 de la station et celui de la station éloignée se superposent dans les impédances R et dans la ligne. En supposant un fonctionnement linéaire, la tension présente à la borne U ainsi qu'à la borne V est donc égale à - R.I.

d) Si la station éloignée est seule à émettre, un courant I/2 circule dans l'impédance R et la tension présente à la borne U est égale à - R.I/2. D'autre part, le courant i circule dans l'impédance r et la tension à la borne V est donc égale à - r.i - R.I/2.

4

Le but étant d'obtenir un signal ne dépendant que de l'état d'émission de la station éloignée, on constate que si l'on choisit les valeurs des impédances r et R et des courants i et I telles que l'on ait la relation : r.i = R.I/2, la tension de la borne de réception V vérifie bien cette condition. Cette tension sera donc égale à - R.I lorsque la station éloignée émet et à -R.I/2 lorsqu'elle n'émet pas.

Il convient cependant de remarquer que la relation r.i = R.I/2 permet d'obtenir des niveaux de tension sur la borne V strictement indépendants de l'état d'émission de la station à condition que les hypothèses initiales soient parfaitement vérifiées. Dans le cas contraire, la tension à la borne de réception V dépendrait de l'état d'émission mais la compensation imparfaite qui en résulterait pourrait, dans certaines conditions, permettre tout de même de détecter l'émission de la station éloignée en comparant la tension de réception à des valeurs de seuil bien choisies.

Un calcul plus précis permettrait d'établir une relation entre R, I, r, i pour réaliser exactement la compensation dans le cas réel. Cette relation doit exprimer la condition que la chute de tension dans les impédances R et r en série observée lorsque l'émetteur considéré est seul à émettre est égale à celle observée quand aucun émetteur n'émet. Cette condition est rigoureuse en fonctionnement linéaire et reste valable sans qu'il soit nécessaire de faire des hypothèses sur l'ordre de grandeur de la résistance r ou du courant i, ni sur l'impédance caractéristique de la ligne.

Ainsi, en supposant un fonctionnement idéal des générateurs de courant, la condition de compensation s'exprime par la relation : R.I/2 = (R/2 + r). i

La condition de compensation pourrait être satisfaite grâce à un dimensionnement approprié des résistances et des sources de courant de l'émetteur-récepteur. Cependant, dans la perspective d'une réalisation intégrée, il faut prévoir des moyens permettant d'ajuster automatiquement les caractéristiques des composants et des circuits de façon à compenser les dispersions de fabrication et les dérives de caractéristiques.

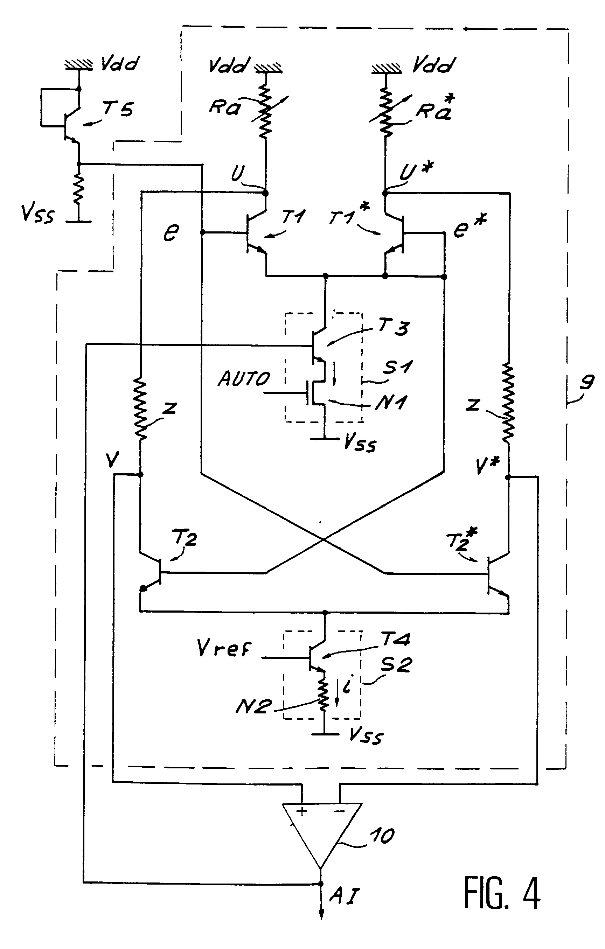

Dans ce but, on prévoit des moyens d'asservissement représentés schématiquement à la figure 2. Cette figure représente un circuit intégré comportant plusieurs émetteurs-récepteurs dont seuls les amplificateurs bidirectionnels 1 sont représentés. Chaque amplificateur 1 est relié à une ligne associée L par l'intermédiaire des plots B du circuit intégré. Le circuit comporte des moyens d'asservissement des courants I et des impédances d'adaptation R des amplificateurs 1. L'asservissement de I est effectué au moyen d'un circuit de commande de courant 2 relié à une impédance d'asservissement Ra de constitution et de dimensionnement fonction des impédances R. Le circuit 2 fournit un signal AI de réglage de courant appliqué à l'entrée de réglage des sources de courant S1 des amplificateurs 1. Le circuit 2 est conçu de façon à régler le courant I des sources de courant pour vérifier la condition de compensation évoquée précédemment. La description détaillée du circuit 2 sera donnée en relation à la figure 4.

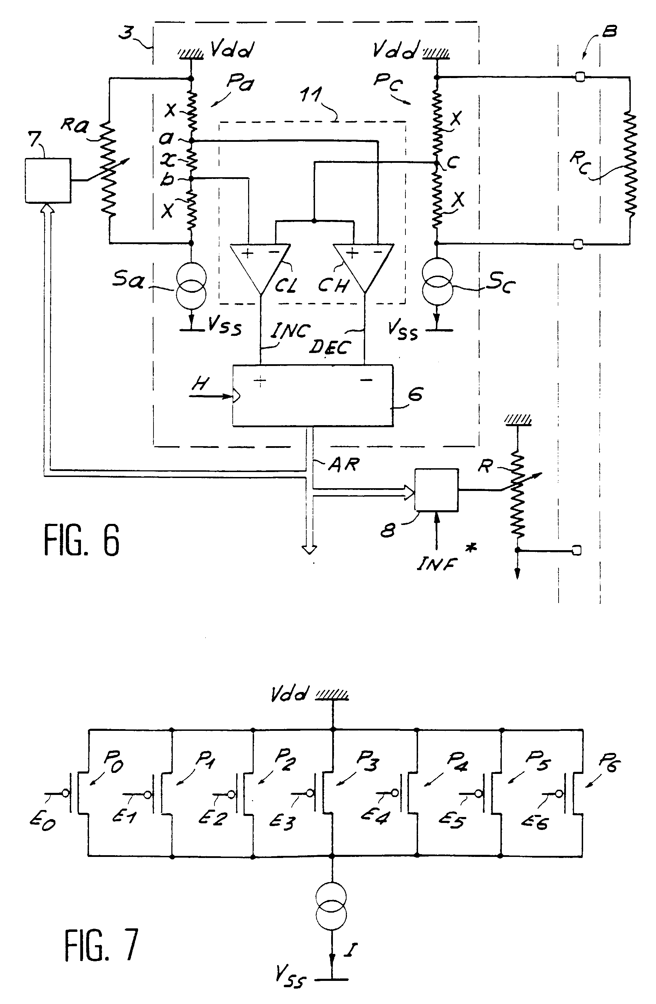

Les moyens d'asservissement des impédances R comportent un circuit de commande de résistance 3 relié à l'impédance d'asservissement Ra et à une impédance calibrée Rc extérieure au circuit intégré. Le circuit 3 fournit un signal de réglage AR de l'impédance d'asservissement Ra et des impédances R des amplificateurs. Le circuit 3 asservit la valeur des résistances Ra et R à la valeur de la résistance calibrée Rc égale à l'impédance caractéristique des lignes L. Le circuit 3 sera décrit en détail en référence à la figure 6.

Les moyens d'asservissement de l'intensité I et des impédances R assurent que la condition de compensation sera vérifiée quelles que soient les dispersions de fabrication et les dérives de caractéristiques tout en maintenant la condition d'adaptation des impédances d'adaptation.

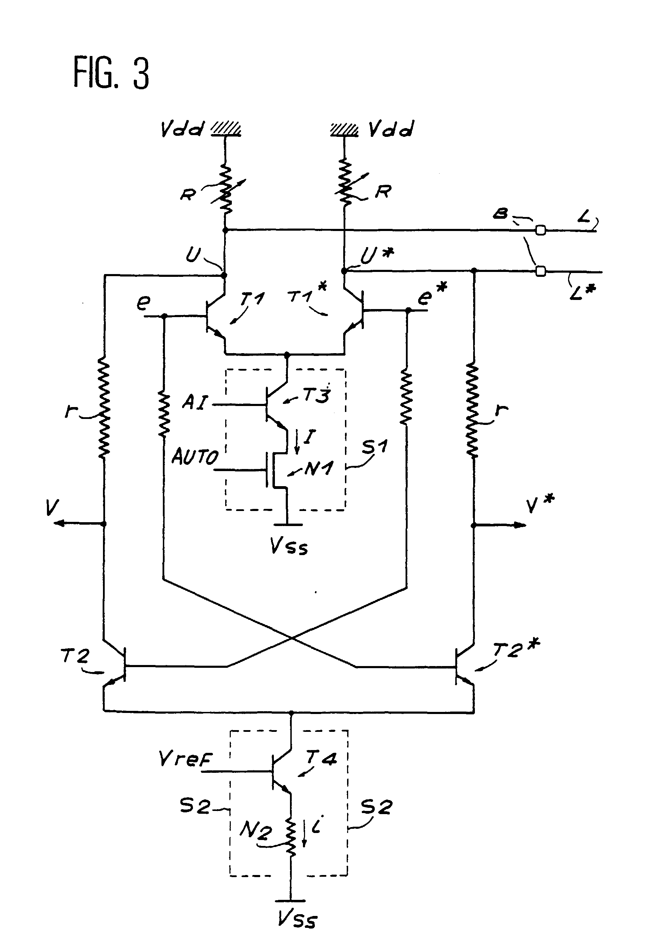

La figure 3 représente une réalisation en technologie BiCMOS d'un amplificateur bidirectionnel de type différentiel. Il est fonctionnellement équivalent à deux amplificateurs bidirectionnels conformes à la figure 1, disposés symétriquement et reliés respectivement aux lignes L, L* d'une liaison différentielle. Comme en mode différentiel une seule des voies est active à la fois, il suffit de prévoir une seule source de courant S1, S2 commune aux générateurs de courant G1, G2, associés aux deux voies.

Ainsi, la voie de gauche associée à la ligne L comporte une impédance d'adaptation R reliée par le point U à la ligne L et au collecteur d'un transistor bipolaire T1 dont l'émetteur est relié à la première source de courant commune S1. La base du transistor T1 reçoit le signal de commande d'émission e. Le collecteur du transistor T1 est relié au collecteur V d'un second transistor T2 par l'intermédiaire de l'impédance r. L'émetteur du transistor T2 est relié à la seconde source de courant commune S2. Symétriquement, la voie de droite reliée à la seconde ligne L* de la liaison différentielle comporte une impédance d'adaptation R reliée par le point U* au collecteur d'un transistor T1* dont l'émetteur est relié à la source de courant commune S1. Le collecteur du transistor T1* est relié au collecteur V* du transistor T2* par l'intermédiaire de l'impédance r. L'émetteur du transistor T2* est relié à la seconde source de courant commune S2. Le transistor T1* reçoit sur sa base le signal e* complément du signal e. Les signaux e et e* constituent des signaux différentiels de commande d'émission. Ces signaux sont complémentaires et représentatifs d'une valeur logique déterminée. Les signaux e et e* sont appliqués respectivement sur la base des transistors T2* et T2, par l'intermédiaire de résistances servant à compenser la constante de temps due à la capacité de structure des impédances R.

La source de courant S1 est constituée d'un transistor bipolaire T3 dont le collecteur est relié aux émetteurs des transistors T1 et T1* et dont l'émetteur est relié au potentiel négatif Vss par l'intermédiaire du chemin drain-source d'un transistor NMOS N1. La base du transistor T3 est commandée par le signal de réglage AI et la grille du transistor N1 reçoit le signal de commande d'alimentation AUTO. De façon analogue, la seconde source de courant S2 est constituée d'un transistor bipolaire T4 dont le collecteur est relié aux émetteurs des transistors T2 et T2* et dont l'émetteur est relié à la tension Vss par l'intermédiaire d'une résistance N2.

Le fonctionnement du circuit de la figure 3 se déduit facilement de celui de la figure 1 grâce aux remarques suivantes. Pour chaque voie, le premier générateur de courant G1 est constitué du transistor T1 ou T1* faisant fonction d'interrupteur et de la première source de courant commune S1. De même, le second générateur de courant G2 est formé du transistor T2 ou T2* et de la seconde source de courant S2. Chaque voie fonctionne alors exactement comme le circuit de la figure 1 mais, compte tenu du mode de fonctionnement différentiel, un seul des signaux de commande d'émission e, e* est actif à la fois, aussi bien pour l'émetteur-récepteur de la station considérée que pour celui de la station éloignée. Il en résulte que, grâce à la compensation décrite précédemment, les tensions présentes aux bornes de mesure V et V* prendront respectivement les valeurs - Rl et -Rl/2 ou - Rl/2 et - Rl selon que la voie de gauche ou la voie de droite de l'émetteur de la station éloignée est active ou non. Les tensions V et V* constituent donc un signal différentiel fonction du signal différentiel d'émission de la station éloignée et pourra être exploité en aval de l'amplificateur après une mise en forme appropriée.

La figure 4 représente un circuit de commande de courant 2 particulièrement adapté pour commander l'amplificateur différentiel de la figure 3. Nous avons vu que la condition de compensation impose que la chute de tension dans les résistances R et r en série doit être la même lorsque l'émetteur considéré est seul à émettre et lorsqu'aucun émetteur n'émet. Par conséquent, le circuit de la figure 4 est conçu de façon à simuler ces deux cas, à comparer les tensions de mesure correspondantes et à régler le courant l de façon à obtenir l'égalité de ces tensions.

Dans ce but, le circuit de la figure 4 comporte un circuit d'asservissement 9 de même constitution et de même dimensionnement pour l'essentiel que l'amplificateur différentiel de la figure 3 mais modifié de façon à réaliser sur ses deux voies les simulations recherchées. En particulier, un signal de commande d'émission différentiel fixe est appliqué aux bases des transistors T1, T1* de façon à les rendre respectivement conducteur et non-conducteur. Pour cela, l'émetteur du transistor T1* est relié à sa base tandis que la base du transistor T1 reçoit une tension positive par rapport à Vss. Cette tension est fournie par un montage comportant un transistor bipolaire T5 dont la base et le collecteur sont reliés à la masse et dont l'émetteur est relié au potentiel Vss par une résistance appropriée. L'émetteur du transistor T5 fournit la tension de base du transistor T1.

D'autre part, l'impédance d'adaptation R et la seconde impédance r sont remplacées respectivement par une impédance d'asservissement Ra, Ra* et une impédance z. Le choix des valeurs de Ra, Ra* et z doit tenir compte du fait que, contrairement au circuit 9, l'émetteur-récepteur a ses impédances d'adaptation R reliées aux lignes et que par conséquent la source de courant S1 alimente une impédance équivalente égale à la moitié de l'impédance d'adaptation. Ainsi, selon une première possibilité, les impédances d'asservissement Ra, Ra* pourraient être réalisées en plaçant en parallèle deux impédances identiques aux impédances d'adaptation R utilisées dans l'émetteur-récepteur. Dans ce cas, l'impédance z serait identique à r.

Selon une autre possibilité, on utilise des impédances d'asservissement Ra, Ra* identiques à l'impédance d'adaptation R, en choisissant pour z une valeur égale au double de celle de la seconde impédance r. L'impédance r sera alors réalisée par la mise en parallèle de deux impédances identiques à z. Cette solution simplifie la réalisation des impédances d'asservissement Ra, Ra* qui, comme les impédances d'adaptation R, sont de préférence réglables. De plus, cette solution permet d'utiliser l'impédance Ra de la voie de gauche pour réaliser l'asservissement des impédances R, comme nous le verrons plus loin.

Selon encore une autre possibilité, les impédances R et Ra d'une part, r et z d'autre part ont la même valeur mais le courant fourni par la source de courant S1 du circuit d'asservissement 9 est moitié de celui fourni par la source S1 de l'amplificateur bidirectionnel. Pour cela, il suffit de dimensionner le transistor N1 du circuit 9 pour qu'il ait une résistance double de celui de l'amplificateur. Dans la mesure où R n'est pas négligeable par rapport à r, il conviendrait que Ra* soit égale à R/2.

Dans tous les cas, toujours en supposant un fonctionnement linéaire, les tensions V et V* sont proportionnelles aux chutes de tension aux bornes des impédances R et r de l'émetteur respectivement lorsqu'il est seul à émettre et lorsqu'aucun émetteur n'émet. Les tensions V et V* sont appliquées respectivement à l'entrée directe et inverseuse d'un amplificateur différentiel 10 à grand gain et forte impédance d'entrée dont la sortie fournit le signal de réglage de courant Al qui est ensuite appliqué à la base des transistors T3 des sources de courant S1 du circuit d'asservissement 9 et des amplificateurs bidirectionnels 1.

Selon une variante de réalisation, l'amplificateur 10 pourrait être remplacé par un montage numérique analogue à celui utilisé pour l'asservissement des impédances comme nous le verrons en détail ultérieurement.

De façon évidente, le circuit de la figure 4 règle le courant l des sources de courant S1 de façon à maintenir en permanence la condition de compensation recherchée.

Le circuit d'asservissement 9 étant pour l'essentiel de même constitution et dimensionnement que les amplificateurs bidirectionnels 1, il reproduit avec une bonne précision leur comportement indépendamment des dispersions de fabrication et tient compte des courants de fuite éventuellement non négligeables des transistors de commutation T1, T1*, T2, T2*.

Bien entendu, ce circuit assure que la condition de compensation sera strictement vérifiée du point de vue statique, ce qui est suffisant en général car l'impédance caractéristique de la ligne, donc les impédances R et r, sont, pour des fréquences élevées, pratiquement des résistances pures. L'homme du métier pourra bien sûr adapter cette réalisation pour mieux tenir compte des caractéristiques réelles de la ligne dans chaque cas particulier.

Selon un aspect intéressant de la réalisation de l'amplificateur bidirectionnel et du circuit d'asservissement, ces derniers comportent une seconde source de courant S2 identique formée du transistor T4 en série avec une résistance N2. Il en résulte que la tension Vref appliquée à la base du transistor T4 fixe la chute de tension dans la résistance N2 et par conséquent le courant i qui la traverse. Ainsi, compte tenu de la condition de dimensionnement imposée par le circuit d'asservissement, le choix de la tension Vref détermine indirectement le produit R.I qui doit être fixé avec précision car il fixe la dynamique des signaux.

Dans le cadre d'une application à un circuit d'interface parallèle-série, série-parallèle pour réaliser l'interconnexion d'un grand nombre d'unités, il est intéressant de prévoir la possibilité de couper l'alimentation des circuits de puissance des émetteurs et récepteurs inactifs. C'est pourquoi les sources de courant S1 sont munies d'un transistor NMOS N1 commandé par un signal de mise sous tension AUTO. Cette disposition présente l'avantage, notamment dans le cas d'une réalisation intégrée, de réduire la consommation du circuit d'interface.

Il convient cependant de tenir compte de cette possibilité dans la conception de la partie réception de l'émetteur-récepteur. En effet, si l'émetteur-récepteur de la station éloignée est à l'état de repos, c'est-à-dire a sa source de courant S1 inactive, aucune des lignes différentielles n'est alimentée par cet émetteur-récepteur. Il en résulte qu'aucune tension différentielle V, V* n'apparaît en sortie de l'amplificateur bidirectionnel, ce qui pourrait provoquer une détection erronée des signaux de réception. Pour éviter cette difficulté, il est prévu un ensemble de moyens dans la partie réception de l'émetteur-récepteur pour traiter ce cas.

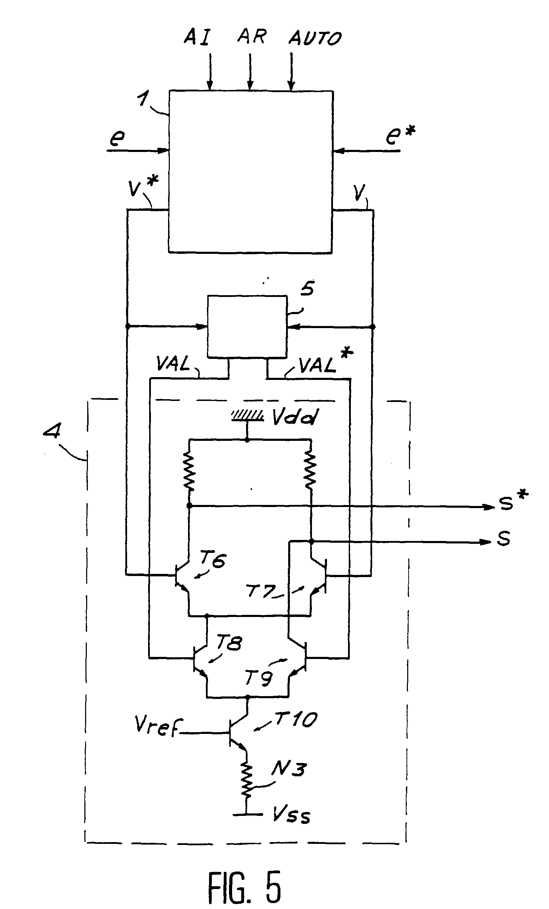

La figure 5 représente la partie réception dans son ensemble. On retrouve évidemment l'amplificateur bidirectionnel 1 qui est associé à un circuit de mise en forme 4 et à un circuit de détection d'activité de ligne 5. Le circuit 5 reçoit les tensions V, V* de l'amplificateur 1 et fournit un signal différentiel VAL, VAL* résultant de la comparaison entre la tension différentielle V, V* et une valeur de seuil déterminée. Le circuit 5 est constitué en fait d'un ensemble de comparateurs pour comparer respectivement les tensions V et V* à une valeur de seuil comprise entre les tensions maximales et minimales pouvant être prises par V et V* lorsque la station éloignée est active. Si l'une des tensions V ou V* est supérieure à ce seuil en valeur absolue, un circuit logique place respectivement à un niveau haut et bas les sorties VAL et VAL* du circuit 5. Dans le cas contraire, les signaux VAL et VAL* sont placés respectivement à des niveaux bas et haut. La réalisation du circuit 5 étant à la portée de l'homme du métier, nous n'en donnerons pas une description plus détaillée.

Le circuit de mise en forme 4 est une porte ET en technologie ECL composée de deux transistors T6, T7 reliés entre eux par leur émetteur et dont les collecteurs sont reliés chacun à la masse par l'intermédiaire d'une résistance. Deux autres transistors T8, T9 ont leur émetteur relié au collecteur d'un cinquième transistor T10 dont l'émetteur est relié à la tension Vss par l'intermédiaire d'une résistance N3. Le collecteur du transistor T8 est relié aux émetteurs des transistors T6 et T7 tandis que le collecteur du transistor T9 est relié au collecteur du transistor T7. La base du transistor T10 reçoit la tension de référence Vref de façon à fixer le courant circulant dans la résistance N3. Les bases des transistors T6 et T7 reçoivent respectivement les tensions V* et V. Les bases des transistors T8 et T9 reçoivent respectivement les signaux d'activité de ligne VAL et VAL*. Les tensions s* et s des collecteurs des transistors T6 et T7 constituent les signaux de réception différentiels utilisables en aval dans le reste du circuit.

Le circuit de la figure 5 fonctionne de la façon suivante. Si la station éloignée est active, il existe une tension différentielle V, V* qui est détectée par le circuit 5 fournissant alors un signal différentiel positif VAL, VAL*. Il en résulte que le transistor T8 est conducteur et que le transistor T9 est bloqué. Le circuit 4 fonctionne alors en amplificateur différentiel produisant sur ses sorties s, s* un signal différentiel fonction de la tension différentielle V, V*.

Si par contre le circuit 5 détecte l'inactivité de la station éloignée, les signaux VAL et VAL* prennent des valeurs complémentaires du cas précédent. Le transistor T8 est alors bloqué et le transistor T9 est conducteur. Il en résulte que le signal s est à l'état bas et le signal s* est à l'état haut, forçant ainsi la sortie différentielle du circuit de mise en forme à la valeur 0 logique.

La description qui précède montre l'intérêt de fixer avec assez de précision la valeur du produit R.I de façon à permettre un bon fonctionnement des comparateurs du circuit de détection 5.

La figure 6 représente les moyens d'asservissement des impédances d'adaptation R. Ils comprennent un comparateur d'impédance 3 relié à une impédance de référence Rc et à une impédance d'asservissement Ra. L'impédance de référence Rc est une impédance calibrée extérieure au circuit intégré et l'impédance Ra est une impédance intégrée réglable de mêmes constitution et dimensionnement que les impédances d'adaptation R à régler.

Le comparateur d'impédance 3 délivre un signal de réglage numérique AR relié aux décodeurs 7, 8 associés respectivement à l'impédance Ra et à chaque impédance d'adaptation R. Chaque décodeur 7, 8 commande la valeur de l'impédance associée. Les décodeurs 8 associés aux impédances d'adaptation R se distinguent du décodeur 7 de l'impédance Ra par la présence d'une entrée supplémentaire INF* prévue pour les opérations de test qui seront expliquées ultérieurement.

Comme pour l'asservissement du courant, la réalisation décrite ci-dessous permet d'ajuster la partie purement résistive des impédances d'adaptation. L'homme du métier pourra modifier cette réalisation pour tenir compte, si nécessaire, des caractéristiques réelles de la ligne.

Le comparateur d'impédance 3 comprend deux ponts diviseurs de tension Pa, Pc branchés en parallèle respectivement avec Ra et Rc. Ces deux montages parallèles sont alimentés respectivement par les sources de courant Sa et Sc identiques. Dans le cas où l'impédance Ra est celle utilisée dans le circuit 9 d'asservissement des courants, la source Sa est en fait la source S1 du circuit 9. Le comparateur 3 comporte également un comparateur de tension 11 relié aux ponts diviseurs Pa et Pc ainsi qu'un compteur-décompteur 6. Le comparateur de tension 11 est en fait constitué de deux comparateurs CL, CH fournissant respectivement un signal INC d'incrémentation appliqué à l'entrée de comptage du compteur-décompteur 6 et un signal de décrémentation DEC appliqué à son entrée de décomptage. Le point milieu c du pont diviseur Pc de résistance 2X est relié à l'entrée inverseuse du comparateur CL et à l'entrée directe du comparateur CH. Le pont diviseur Pa comporte deux bornes intermédiaires a, b telles que la résistance X entre le point a et la masse et la résistance entre le point b et la source de courant Sa soient égales, une résistance x entre les points a et b étant égale à une fraction de X. Le point a est relié à l'entrée inverseuse du comparateur CH et le point b est relié à l'entrée directe du comparateur CL. Cette disposition permet par un dimensionnement approprié de X et x de produire un effet d'hystérésis tel que les signaux d'incrémentation INC ou de décrémentation DEC soient actifs lorsque la valeur de l'impédance d'asservissement Ra est respectivement inférieure ou supérieure à la valeur de l'impédance de référence Rc d'une valeur de seuil déterminée. Ceci présente l'avantage d'éviter une instabilité dans la régulation des impédances d'adaptation.

Cette valeur de seuil sera définie par un pourcentage d'erreur imposé et portant sur la valeur de Rc. On peut constater d'autre part que le fonctionnement du comparateur 3 est pratiquement indépendant des dispersions de fabrication, dans la mesure où X est suffisamment grand par rapport à Rc, ce qui est toujours possible.

Ainsi, l'état du compteur-décompteur 6 est représentatif de la valeur de réglage à appliquer aux impédances R et Ra pour que leur valeur soit égale à la valeur de l'impédance de référence Rc à un pourcentage d'erreur près.

L'asservissement de la figure 6 est donc du type à commande numérique. On aurait pu imaginer une solution analogique utilisant par exemple des transistors PMOS, les résistances des chemins drain-source constituant les impédances réglables R et Ra, les grilles étant commandées par un signal de réglage analogique représentatif de la différence entre la valeur de l'impédance calibrée Rc et celle de l'impédance d'asservissement Ra. Or, cette solution présente l'inconvénient que le signal de réglage analogique est exposé à des altérations lors de sa transmission dans le circuit, en particulier dans le cas d'un circuit intégré comportant un grand nombre d'émetteurs-récepteurs.

La réalisation numérique de la figure 6 résout donc ce problème. L'utilisation, suggérée ci-dessus, de transistors PMOS comme impédances réglables serait possible en leur associant des circuits de conversion numérique-analogique. Cependant, cette solution nécessiterait d'utiliser des transistors volumineux dont la capacité de structure pourrait perturber le fonctionnement à très haute fréquence.

Une solution entièrement numérique est donc préférable. Pour cela, chaque impédance variable est réalisée au moyen d'une pluralité de résistances branchées sélectivement en parallèle par un signal de réglage numérique. On peut noter que le cas de l'impédance Ra est légèrement différent de celui des impédances R car il n'est pas nécessaire de prévoir la possibilité pour Ra de prendre une valeur infinie pour les opérations de test. Par conséquent, l'une des résistances de Ra pourra être branchée en permanence.

La figure 7 représente une telle réalisation où chaque résistance est constituée d'un transistor PMOS P0-P6. Les transistors sont branchés en parallèle, leurs sources étant reliées à la masse et leurs drains à la source de courant associée. Les grilles des transistors P0-P6 sont commandées respectivement par les signaux E0-E6. La résistance du chemin drain-source de chaque transistor prend alors une valeur qui dépend du dimensionnement du transistor (sa largeur de grille par exemple) ainsi que du procédé de fabrication, avec une incertitude autour d'une valeur typique correspondant au cas le plus probable.

On pourrait imaginer de choisir un dimensionnement des résistances P0-P6 de façon à réaliser une pondération d'un code binaire (les résistances sont toutes différentes et proportionnelles à une puissance de 2) mais cette réalisation pose le problème des commutations simultanées de plusieurs résistances qui pourraient provoquer des perturbations au niveau des lignes.

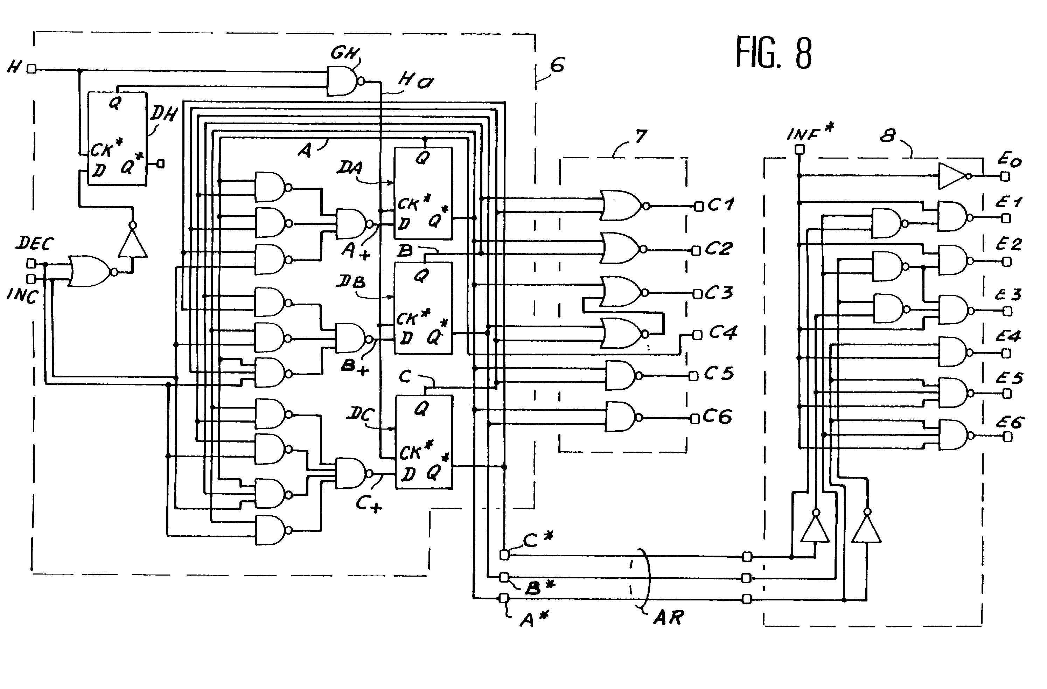

Pour éviter ce problème, il est préférable d'utiliser des résistances dimensionnées de façon à ce que leurs activations successives conduisent à des valeurs régulièrement décroissantes de la résistance équivalente en résultant. En contrepartie, ceci entraîne, pour une précision donnée, une augmentation du nombre de résistances et donc du nombre de signaux de commande. Aussi, pour compenser cet inconvénient, la solution choisie consiste à utiliser comme signal de réglage AR un signal de réglage numérique codé et à associer à chaque impédance à régler un décodeur 7, 8 correspondant. Le code utilisé est avantageusement un code de Gray fourni directement par le compteur-décompteur 6. Une réalisation détaillée de ce compteur-décompteur et des décodeurs associés est représentée à la figure 8.

Avant de décrire la figure 8, il convient de donner un exemple de réalisation détaillée des circuits précédents.

L'impédance caractéristique de la ligne étant de 50 ohms, on impose par exemple une erreur de moins de 5 % sur les impédances d'adaptation, dans les limites d'une dispersion d'environ 25 % sur les valeurs des composants.

Les impédances d'adaptation doivent alors pouvoir varier régulièrement entre 37 et 63 ohms environ dans le cas typique. Les calculs et les simulations conduisent alors à une solution à 7 transistors PO à P6 de résistances croissantes dont les dimensionnements sont faciles à calculer en fonction de la technologie employée.

D'autre part, les signaux d'incrémentation INC ou de décrémentation DEC doivent s'activer lorsque l'impédance Ra est respectivement inférieure ou supérieure de 5 % à l'impédance Rc. Les calculs montrent alors, avec Rc = 50 ohms, que l'on peut prendre X = 500 ohms et x = 50 ohms. En prenant R.I. = O,5 V, il en résulte une immunité au bruit pour un niveau de bruit inférieur à 3,3 mV.

La figure 8 représente le compteur-décompteur 6 et les décodeurs 7 et 8 dans le cas particulier où les impédances d'adaptation comportent 7 transistors PMOS en parallèle.

Le décodeur 7 associé à Ra possède seulement 6 sorties C1 à C6 reliées respectivement aux grilles des transistors P1 à P6. Le transistor P0 est rendu conducteur en permanence par une polarisation négative de sa grille. Lorsqu'une sortie C1-C6 du décodeur 7 prend la valeur 0 logique, le transistor qu'elle commande P1-P6 est rendu conducteur.

Le décodeur 8 comporte 7 sorties E0 à E6 et a un fonctionnement analogue au décodeur 7 à la différence près que le premier transistor P0 peut être conducteur ou bloqué selon que la sortie E0 est à 0 ou à 1.

Le compteur-décompteur 6 comprend trois bascules DA, DB, DC de type D définissant l'état du compteur. Les bascules DA, DB, DC reçoivent respectivement sur leurs entrées D les signaux logiques $A_+$, $B_+$, $C_+$ fournis par un ensemble de portes logiques en fonction des signaux INC et DEC et des états A, B, C des bascules DA, DB, DC.

Ce circuit logique effectue les équations suivantes :

$$(1) \qquad A_+ = [(A.B^*)^*.(A.C)^*.(C^*.INC)^*]^*$$

$$(2) \qquad B_+ = [(B.C^*)^*.(A^*.INC)^*.(A.C.DEC)^*]^*$$

$$(3) \qquad C_+ = [(A^*.B^*)^*.(A^*.DEC)^*.(B^*.DEC)^*.(A.B.INC)^*]^*$$

où le symbole * indique l'opération de complémentation.

Grâce à cette logique de commande, le compteur peut prendre sept états différents, l'état 000 étant interdit. Chaque état A, B, C correspond à la valeur codée en code de Gray du nombre de transistors qui doivent être à l'état conducteur. Cette disposition implique que toute modification imposée à la valeur des impédances à régler se traduit par le changement d'état d'une seule des bascules DA, DB, DC à la fois.

Afin d'améliorer la sécurité de fonctionnement du compteur-décompteur, les bascules sont synchronisées par les fronts descendants d'un signal d'horloge Ho fonction d'un signal primaire H et de l'état d'une bascule supplémentaire DH. La bascule DH reçoit sur son entrée d'horloge inverse CK* le signal d'horloge H et sur son entrée D la somme logique DEC+INC. Le signal d'horloge H et la sortie non inverseuse Q de la bascule DH sont reliés aux entrées d'une porte NON-ET (NAND) GH délivrant le signal Ho aux entrées d'horloge inverses CK* des bascules DA, DB, DC.

Le compteur-décompteur 6 fonctionne de la façon suivante. Lorsque l'écart en valeur absolue entre les valeurs de Ra et de Rc est inférieur au seuil, les signaux DEC et INC restent à 0. Lors d'un front descendant du signal d'horloge H, la bascule DH est mise à 0 et la sortie Ho de la porte GH est maintenue à 1, ce qui interdit tout changement d'état des bascules DA, DB, DC. Si par contre l'écart entre Ra et Rc dépasse le seuil, l'un des signaux DEC ou INC est à 1 et l'entrée D de la bascule DH reçoit la valeur 1 logique. A l'apparition du front descendant d'horloge suivant, l'état de la bascule DH repasse à 1 et la sortie de la porte GH délivre un signal complémentaire du signal d'horloge H. La sortie de la porte GH est donc à 1 mais repasse à 0 à l'apparition du front montant suivant de H et les bascules DA, DB, DC sont réactualisées conformément aux équations (1), (2), (3) précédentes.

Le fonctionnement qui vient d'être décrit montre que le compteur-décompteur n'est activé que lorsqu'une modification doit avoir lieu et ceci permet de simplifier le circuit logique de commande des bascules. De plus, grâce à la bascule DH et à la porte GH, les bascules DA, DB, DC sont parfaitement synchronisées par l'horloge H sans risque de perturbation par l'apparition des signaux INC ou DEC.

Les décodeurs 7 et 8 reçoivent les signaux d'état A, B, C des bascules DA, DB, DC ou leur complément et fournissent en sortie les signaux C1-C6 ou E0-E6 commandant les impédances variables associées.

Les sorties C1-C6 du décodeur 7 vérifient les équations suivantes :

$$(4) \qquad C1 = (B + C)^*$$

$$C2 = (A^* + B)^*$$

$$C3 = [A^* + (B^* + C)^*]^*$$

$$C4 = A$$

$$C5 = (A^*. C)^*$$

$$C6 = (A^* . B^*)^*$$

Le décodeur 8 est prévu pour pouvoir commander son impédance à la valeur infinie lorsque le signal de test INF est à 1. D'autre part, pour limiter le nombre de lignes reliant le décompteur-décompteur 6 aux différents décodeurs 8 du circuit intégré, seuls les signaux A\*, B\*, C\* issus des sorties inverseuses des bascules DA, DB, DC sont appliqués à l'entrée du décodeur 8. Compte tenu de ces contraintes, le décodeur 8 est conçu de façon à réaliser les équations logiques suivantes :

$$(5) \qquad E0 = INF$$

$$E1 = (B^* .C^* .INF^*)^*$$

$$E2 = (A.B^*.INF^*)^*$$

$$E3 = (A.B^*)^*. (A.C)^*.INF^*$$

$$E4 = (A^*.INF^*)^*$$

$$E5 = (A^*.C.INF^*)^*$$

$$E6 = (A^* .B^*.INF^*)^*$$

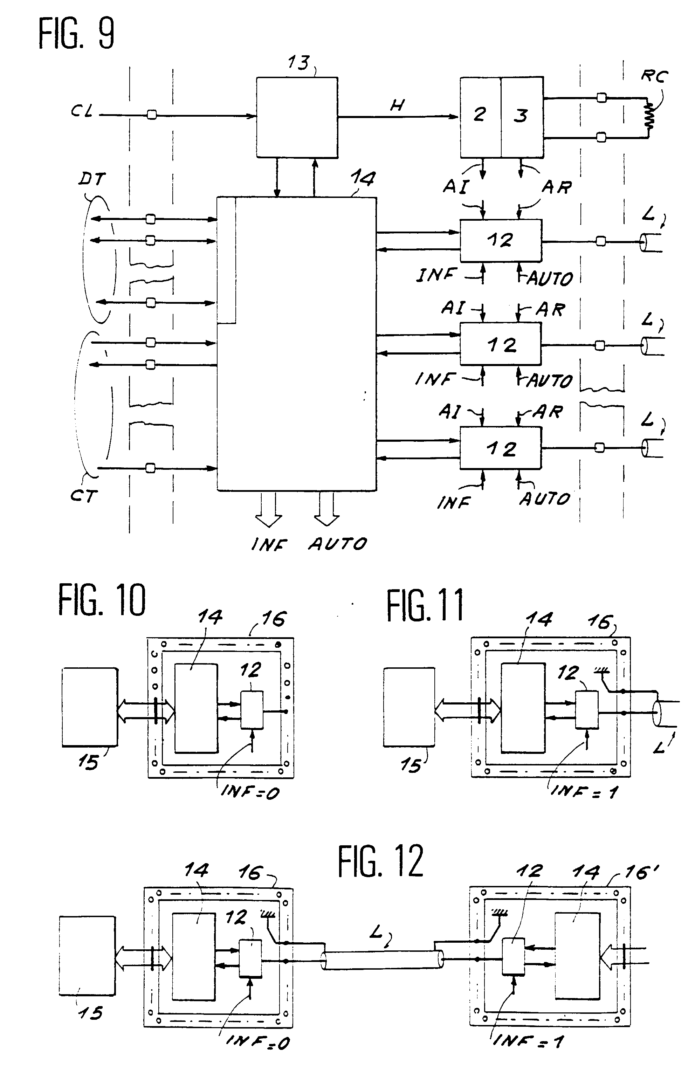

La figure 9 représente un circuit d'interface parallèle-série, série-parallèle dans lequel l'invention peut s'appliquer avantageusement. Ce circuit est supposé être réalisé sous forme de circuit intégré prévu pour être relié d'une part à des lignes d'entrée-sortie parallèles composées de lignes de données DT et de lignes de contrôle CT et d'autre part à des lignes de transmission série L.

Le circuit comprend des moyens de sérialisation-désérialisation 14 reliés aux entrées-sorties parallèles DT, CT ainsi qu'aux divers émetteurs-récepteurs 12 par des lignes d'émission et de réception série associées. Chaque émetteur-récepteur 12 est relié à une ligne de transmission bidirectionnelle L par l'intermédiaire d'un amplificateur 1 conforme à la description précédente. Chaque ligne L relie l'émetteur-récepteur associé à un autre émetteur-récepteur appartenant à une station éloignée.

Le circuit intégré comprend également les moyens d'asservissement 2, 3 du courant I et des impédances d'adaptation R des amplificateurs. Enfin, un générateur d'horloge 13 recevant un signal d'horloge maître CL fourni par une horloge extérieure pilote les moyens de sérialisation-désérialisation 14. En émission, le générateur 13 fonctionne en multiplieur de fréquence de façon à adapter le débit d'émission des données série au débit de réception des données parallèles. En réception, le générateur 13 effectue la régénération d'un signal d'horloge à la fréquence des données série à partir de ces données et effectue une division de fréquence pour contrôler la partie parallèle du sérialiseur-désérialiseur.

Les circuits 13 et 14 font l'objet d'un exemple de réalisation détaillée dans chacune des demandes de brevet français suivantes déposées le 11.07.90 : "Procédé et système de transmission numérique de données en série", n° 90.08811 ; "Dispositif de sérialisation et de désérialisation de données et système de transmission numérique de données en série en résultant", n° 90.08812 ; "Dispositif d'échantillonnage de données et système de transmission numérique de données en résultant", n° 90.08813.

Le circuit 14 comprend en outre des moyens pour sélectionner les émetteurs-récepteurs et leur fournir les signaux INF et AUTO en vue d'effectuer respectivement les opérations de test et la coupure d'alimentation des amplificateurs associés aux lignes inactives.

Le fonctionnement du circuit de la figure 9 est en grande partie classique et ne nécessite donc pas d'explication détaillée. Pour plus de précisions, on pourra se reporter aux demandes de brevet citées ci-dessus.

Il convient cependant de préciser que les moyens de sérialisation-désérialisation 14 comportent des circuits de contrôle de l'activité des émetteurs-récepteurs en fonction de commandes CT indiquant la station destinataire. Réciproquement, ces circuits sont prévus pour délivrer des signaux de contrôle sur l'interface parallèle en réponse à l'identité des lignes actives en réception. D'autre part, on peut prévoir des circuits de décodage fournissant les signaux INF et AUTO aux émetteurs-récepteurs désignés par des commandes CT appropriées. La réalisation pratique de ces circuits dépend essentiellement de l'interface parallèle choisie. Par exemple, si les commandes CT comportent une partie adresse et une partie contrôle, la partie adresse servira d'entrée à des décodeurs d'adresse. Des signaux de commande de test et de commande d'alimentation de la partie contrôle seront utilisés pour valider un des signaux INF ou AUTO sélectionné par le décodeur d'adresse.

Les figures 10, 11 et 12 symbolisent les opérations de test pouvant être effectuées sur le circuit intégré de la figure 9. Sur ces figures, le sérialiseur-désérialiseur 14 du circuit intégré 16 est relié par ses entrées-sorties parallèles à un appareil de test 15. Comme précédemment, le circuit 14 est relié aux émetteurs-récepteurs 12 dont un seul est représenté pour des raisons de clarté.

Selon une première possibilité illustrée à la figure 10, le circuit intégré 16 est testé après fabrication, avant d'être connecté aux lignes de transmission série. Dans ce cas, le testeur 15 commande la mise à 0 du signal INF de l'émetteur-récepteur à tester, ce qui entraîne que sa source de courant alimente les impédances d'adaptation dans leur configuration normale. Le testeur 15 commande ensuite l'émission par cet émetteur-récepteur d'un ensemble de données appliquées aux entrées parallèles du circuit 14. Le circuit 14 les convertit en données série et les transmet à l'émetteur-récepteur 12 sélectionné. En fonction des données série reçues, l'amplificateur 1 de l'émetteur-récepteur 12 reçoit des signaux de commande d'émission qui activent en conséquence les sources de courant alimentant les impédances d'adaptation.

Comme la ligne n'est pas branchée, la source S1 alimente seulement l'impédance d'adaptation R de la voie active, donc débite sur une impédance double de l'impédance équivalente qu'elle alimente lorsque l'émetteur-récepteur est en fonctionnement normal. Par conséquent, la tension V ou V* de la voie active prend la valeur - R.I. D'autre part, la tension V* ou V de la voie inactive prend la valeur - (R + r)i, c'est-à-dire pratiquement - RI/2.

Les tensions V et V* qui apparaissent sur les bornes de réception de l'amplificateur 1 reproduisent donc les signaux de commande d'émission qui, après mise en forme et conversion en données parallèles, sont reçus par l'appareil de test 15. Ce dernier effectue alors la comparaison entre les données parallèles émises initialement et celles reçues. S'il y a coïncidence, cela signifie que les circuits 13, 14 et 12 ont fonctionné correctement.

La même opération est ensuite effectuée en sélectionnant successivement les autres émetteurs-récepteurs du circuit.

Ainsi, grâce à la conception particulière des émetteurs-récepteurs, les opérations de test du circuit intégré sont très simples et permettent de vérifier non seulement le bon fonctionnement des émetteurs-récepteur mais aussi de tous les circuits annexes et intermédiaires tels que le sérialiseur-désérialiseur 14.

Des tests peuvent aussi être effectués alors que le circuit intégré est en place dans un système, ses émetteurs-récepteurs étant reliés aux lignes de transmission L.

Selon une première possibilité illustrée à la figure 11, l'appareil de test 15 commande la mise à 1 du signal INF de l'émetteur-récepteur à tester, ce qui force ses impédances d'adaptation à la valeur infinie. La source de courant de son amplificateur 1 alimente les seules lignes de transmission L. Comme les impédances d'adaptation ont une valeur égale à l'impédance caractéristique des lignes, nous nous retrouvons dans la même situation qu'à la figure 10 et le test peut être effectué de la même façon.

Dans ce cas, le test donne une indication supplémentaire sur l'intégrité des connexions entre l'émetteur-récepteur et les bornes du circuit intégré et des connexions entre les bornes et les lignes.

On peut noter que les deux tests précédents simulent le fonctionnement normal de façon rigoureuse dans le cas d'une transmission sans perte de courant.

Selon une autre possibilité illustrée à la figure 12, les émetteurs-récepteurs de deux circuits intégrés 16, 16' sont reliés entre eux par les lignes L et l'appareil de test commande la mise à 0 du signal INF de l'émetteur-récepteur du circuit intégré à tester 16 et la mise à 1 du signal INF de l'émetteur-récepteur correspondant de l'autre circuit intégré 16'.

Dans ce cas, l'émetteur-récepteur 12 du circuit 16 est dans sa configuration normale, tandis que celui du circuit 16' a ses impédances d'adaptation déconnectées.

Ainsi, la ligne L est ouverte à son extrémité qui est reliée au circuit 16' et par conséquent, les signaux émis par le circuit 16 sont transmis par la ligne vers le circuit 16', y sont réfléchis puis retransmis par la ligne vers le circuit 16. Il en résulte que la réflexion des signaux simule une émission du circuit 16' et une transmission par une ligne de longueur double de celle de la ligne réelle, avec possibilité de collisions entre les signaux émis et les signaux reçus.

Le test peut donc être effectué comme précédemment mais il fournira une indication supplémentaire sur l'intégrité de la ligne et des connexions entre la ligne et l'émetteur-récepteur de la station éloignée. De plus, ce test prend en compte les éventuelles pertes de courant au cours de la transmission. Enfin, l'effet de réflexion peut être exploité pour localiser les défauts de ligne par analyse des signaux de réception et du retard entre l'émission et la réception des signaux de test.

Il est intéressant de remarquer que les deux dernières possibilités de test peuvent avantageusement être combinées pour localiser les défauts. Ainsi, si le test selon la figure 12 révèle un défaut, le test selon la figure 11 indiquera si le défaut est dû ou non au circuit 16.

Dans le contexte d'un circuit d'interface parallèle-série, série-parallèle, les procédés de test précédents sont particulièrement avantageux dans le cas d'une liaison à haut débit car uniquement des signaux à basse fréquence sont échangés entre l'appareil de test et le circuit intégré à tester.

Selon une variante de réalisation du circuit intégré, on y inclut des circuits de test, commandés de l'extérieur, capables d'engendrer automatiquement des signaux de test parallèles, d'effectuer les comparaisons et de mémoriser les résultats de ces comparaisons dans des registres accessibles de l'extérieur.

Ce circuit de test comprendra un générateur de signaux de test, par exemple un générateur de signaux aléatoires, commandé par un circuit d'activation qui sera programmé pour déclencher l'envoi d'un nombre déterminé de mots de test. Comme l'horloge de réception est régénérée à partir des signaux série reçus, elle est indépendante de l'horloge d'émission. Aussi, les circuits de comparaison devront être conçus pour tenir compte des décalages entre les signaux émis et les signaux reçus. Ceci peut être réalisé au moyen de mémoires tampons. Cependant une réalisation moins encombrante consiste à associer aux circuits de comparaison un générateur de signaux de test identique à celui d'émission, programmé de la même façon et synchronisé par l'horloge de réception. Cette réalisation permet de supprimer les mémoires tampons ainsi que les circuits de resynchronisation qui seraient nécessaires autrement.

Le fait de prévoir les circuits de test à l'intérieur du circuit intégré présente le double avantage de ne pas nécessiter un appareil de test extérieur et de permettre une bien meilleure exhaustivité des tests. En effet, l'utilisation d'un appareil de test ralentirait considérablement les opérations de test à cause de la désynchronisation entre l'émission et la réception, ce qui implique de nombreuses opérations d'écriture et de lecture dans la mémoire de l'appareil de test.

La réalisation des générateurs de signaux de test, des moyens de comparaison et de mémorisation est à la portée de l'homme du métier et ne nécessite donc pas une description plus détaillée.

**Revendications**

1. Emetteur-récepteur prévu pour être relié par une liaison de transmission à un autre émetteur-récepteur analogue, ladite liaison comportant au moins une ligne de transmission (L, L*), ledit émetteur-récepteur comportant des moyens d'amplification pour produire des signaux d'émission sur ladite liaison en réponse à des signaux de commande d'émission (e, e*) et pour produire des signaux de réception (s, s*) en réponse aux signaux d'émission produits sur ladite liaison par l'autre émetteur-récepteur, lesdits moyens d'amplification comportant pour chaque ligne de transmission (L, L*) un amplificateur bidirectionnel (1) comprenant une première impédance (R) d'adaptation à la ligne et connectée à celle-ci, ledit émetteur-récepteur étant caractérisé en ce que ledit amplificateur bidirectionnel comprend:

   - un premier générateur (G1) commandé en réponse auxdits signaux de commande d'émission (e, e*) pour fournir un courant à ladite première impédance (R) et à ladite ligne (L, L*), alimentées en parallèle,
   - des moyens de détection (G2, r) commandés en réponse auxdits signaux de commande d'émission (e, e*) pour fournir un signal de mesure (V) qui est représentatif soit du courant circulant dans l'impédance d'adaptation (R) lorsque ledit premier générateur (G1) est actif, soit de la somme du courant circulant dans l'impédance d'adaptation (R) et d'une valeur de compensation lorsque ledit premier générateur (G1) n'est pas actif,

   ladite valeur de compensation étant déterminée de façon à satisfaire à une condition de compensation selon laquelle ledit signal de mesure (V) ne dépend pratiquement que des signaux d'émission produits par l'autre émetteur-récepteur.

2. Emetteur-récepteur selon la revendication 1 caractérisé en ce que lesdits moyens de détection comportent une seconde impédance (r) dont une première borne est reliée à un point commun (U) à l'impédance d'adaptation et à la ligne, et un second générateur (G2) commandé en réponse aux signaux de commande d'émission et de même polarité que ledit premier générateur (G1) pour alimenter en courant la seconde borne (V) de la seconde impédance (r), appelée borne de réception, en ce que lesdits premier et second générateurs (G1, G2) sont commandés en réponse auxdits signaux de commande d'émission (e, e*) de façon à ce que le premier générateur (G1) soit actif alors que le second générateur (G2) ne l'est pas et réciproquement, et en ce que ledit signal de mesure est la tension présente sur ladite borne de réception (V), ladite valeur de compensation étant la tension aux bornes de ladite seconde impédance (r), lesdits générateurs (G1, G2) et ladite seconde impédance (r) étant dimensionnés de façon à satisfaire ladite condition de compensation.

3. Emetteur-récepteur selon la revendication 2, caractérisé en ce que ledit premier générateur (G1) comporte une source de courant (S1) réglable et commandée par des premiers moyens d'asservissement (2) tels que ladite condition de compensation soit satisfaite.

4. Emetteur-récepteur selon la revendication 3, caractérisé en ce qu'il fait partie d'un circuit intégré et en ce que la première impédance (R) est réglable et commandée par des seconds moyens d'asservissement (3) tels que ladite première impédance (R) prenne une valeur égale à celle d'une impédance calibrée (Rc) extérieure au circuit intégré et ayant la valeur de l'impédance caractéristique de la ligne.

5. Emetteur-récepteur selon la revendication 4, caractérisé en ce que, sous la commande d'un signal de test (INF), ladite première impédance (R) peut être mise à l'état de haute impédance.

6. Emetteur-récepteur selon la revendication 4 ou 5, caractérisé en ce que ladite première impédance réglable (R) est réalisée au moyen de transistors à effet de champ (P0 - P6) dont les chemins drain-source sont branchés en parallèle et rendus sélectivement conducteurs par lesdits seconds moyens d'asservissement (3).

7. Emetteur-récepteur selon l'une des revendications 3 à 6, caractérisé en ce que le courant (I) de ladite source de courant (S1) est fourni par le collecteur d'un transistor bipolaire (T3) dont l'émetteur est relié à un second potentiel (Vss) par l'intermédiaire d'une résistance (N1) et en ce que lesdits premiers moyens d'asservissement (2) commandent la tension de base dudit transistor bipolaire (3).

8. Emetteur-récepteur selon la revendication 7, caractérisé en ce que ladite résistance (N1) est constituée par le chemin drain-source d'un transistor à effet de champ dont la grille est polarisée par un signal (AUTO) de mise sous tension desdits moyens d'amplification.

9. Emetteur-récepteur selon l'une des revendications 2 à 6, caractérisé en ce que, ladite liaison comprenant deux lignes de transmission (L, L*), lesdits moyens d'amplification comportent deux voies formées de deux amplificateurs bidirectionnels (1) associés respectivement auxdites lignes de transmission, en ce que lesdits amplificateurs bidirectionnels sont commandés respectivement par deux signaux différentiels de commande d'émission (e, e*), en ce que l'un des signaux différentiels de commande d'émission (e) commande le premier générateur (G1) du premier amplificateur ainsi que le second générateur (G2*) du second amplificateur, l'autre desdits signaux différentiels de commande d'émission (e*) commande le premier générateur (G1*) du second amplificateur bidirectionnel ainsi que le second générateur (G2) du premier amplificateur bidirectionnel et en ce que lesdits signaux de réception (s, s*) sont fonction de la tension différentielle (V, V*) présente entre les bornes de réception des deux amplificateurs bidirectionnels.

10. Emetteur-récepteur selon la revendication 9, caractérisé en ce que lesdits premiers générateurs (G1, G1*) sont des générateurs de courant et comportent une première source de courant commune (S1), en ce que chaque premier générateur de courant (G1, G1*) comprend un premier interrupteur (T1, T1*) reliant ladite première source de courant (S1) commune à ladite première borne (U) de la deuxième impédance (r) et en ce que lesdits premiers interrupteurs (T1, T1*) sont commandés respectivement par lesdits signaux différentiels de commande d'émission (e, e*).

11. Emetteur-récepteur selon la revendication 10, caractérisé en ce que lesdits seconds générateurs (G2, G2*) sont des générateurs de courant et comportent une source de courant commune (S2), en ce que chacun desdits seconds générateurs de courant comprend un second interrupteur (T2, T2*) reliant ladite seconde source de courant commune (S2) à ladite borne de réception (V) et en ce que le second interrupteur (T2, T2*) qui est associé à une ligne de transmission (L, L*) est commandé par le signal différentiel de commande d'émission (e*, e) qui commande le premier interrupteur (T1, T1*) associé à l'autre ligne de transmission (L, L*).

12. Emetteur-récepteur selon la revendication 11, caractérisé en ce que ladite première source de courant commune (S1) est réglable et commandée par des premiers moyens d'asservissement (2) qui comportent un circuit d'asservissement (9) constitué de deux amplificateurs bidirectionels, chaque amplificateur bidirectionnel comprenant une première impédance (Ra, Ra*), un premier générateur (G1) commandé en réponse à des signaux de commande d'émission (e, e*) pour fournir un courant à ladite première impédance (Ra, Ra*), des moyens de détection (G2, r) pour fournir un signal de mesure (V) qui est représentatif soit du courant circulant dans l'impédance (Ra, Ra*) lorsque ledit premier générateur (G1) est actif, soit de la somme du courant circulant dans l'impédance (Ra, Ra*) et d'une valeur de compensation lorsque ledit premier générateur (G1) n'est pas actif, lesdits moyens de détection comportant une seconde impédance (z) dont une première borne est reliée à un point commun (U) à l'impédance (Ra,Ra*) et audit générateur (G1), dont la seconde borne (V) est alimentée par un second générateur (G2) commandé et de même polarité que ledit premier générateur (G1), lesdits premier et second générateurs (G1, G2) étant commandés en réponse auxdits signaux de commande d'émission (e, e*) de façon à ce que le premier générateur (G1) soit actif alors que le second générateur (G2) ne l'est pas et réciproquement, ledit signal de mesure étant la tension présente sur ladite borne de réception (V), ladite valeur de compensation étant la tension aux bornes de ladite seconde impédance (r), lesdits générateurs (G1, G2) et ladite seconde impédance (r) étant dimensionnés de façon à satisfaire ladite condition de compensation, lesdits amplificateurs bidirectionnels étant commandés respectivement par deux signaux différentiels de commande d'émission (e, e*), tel que l'un des signaux différentiels de commande d'émission (e) commande le premier générateur (G1) du premier amplificateur ainsi que le second générateur (G2*) du second amplificateur, l'autre desdits signaux différentiels de commande d'émission (e*) commande le premier générateur (G1*) du second amplificateur bidirectionnel ainsi que le second générateur (G2) du premier amplificateur bidirectionnel, ledit circuit d'asservissement étant dimensionné et polarisé de façon à simuler une émission sur une voie et l'absence d'émission sur l'autre voie et en ce que lesdits premiers moyens d'asservissement (2) comportent en outre un comparateur de tension (10) dont les entrées sont reliées respectivement aux bornes de réception (V, V*) des amplificateurs dudit circuit d'asservissement et dont la sortie commande les premières sources de courant (S1) dudit circuit d'asservissement (9) et desdits amplificateurs bidirectionnels (1).

**13.** Emetteur-récepteur selon la revendication 12, caractérisé en ce que lesdits premiers et seconds interrupteurs (T1, T1*, T2, T2*) sont des transistors bipolaires dont les chemins émetteurs-collecteurs relient respectivement la première et la seconde source de courant commune (S1, S2) à, respectivement, ladite première borne (U) de la seconde impédance (r) et ladite borne de réception (V, V*) dudit amplificateur bidirectionnel (1).

**14.** Emetteur-récepteur selon la revendication 13, caractérisé en ce que ladite première source de courant commune (S1) comprend un troisième transistor bipolaire (T3) dont l'émetteur est relié à un second potentiel (Vss) par l'intermédiaire d'une première résistance (N1) et dont le collecteur est relié aux émetteurs des premiers transistors bipolaires (T1, T1*) et en ce que la base dudit troisième transistor (T3) est reliée à la sortie du comparateur (10) desdits premiers moyens d'asservissement (2).

**15.** Emetteur-récepteur selon la revendication 14 caractérisé en ce que ladite seconde source de courant commune (S2) comprend un quatrième transistor bipolaire (T4) dont l'émetteur est relié au second potentiel (Vss) par l'intermédiaire d'une seconde résistance (N2) et dont le collecteur est relié aux émetteurs des seconds transistors bipolaires (T2, T2*) et en ce que la base dudit quatrième transistor (T4) est polarisée (Vref) de façon à fixer la valeur du produit R.I, où R est la valeur de la première impédance et I est la valeur du courant fourni par la seconde source de courant commune (S2).

**16.** Circuit intégré, comportant une pluralité d'émetteurs-récepteurs prévus chacun pour être relié par une liaison de transmission à un autre émetteur-récepteur analogue, ladite liaison comportant au moins une ligne de transmission (L, L*), chaque émetteur-récepteur comportant des moyens d'amplification pour produire des signaux d'émission sur ladite liaison en réponse à des signaux de commande d'émission (e, e*) et pour produire des signaux de réception (s, s*) en réponse aux signaux d'émission produits sur ladite liaison par l'autre émetteur-récepteur, ledit circuit intégré étant caractérisé en ce que:
lesdits moyens d'amplification comportent pour chaque ligne de transmission (L, L*) un amplificateur bidirectionnel (1) comprenant:

- une première impédance réglable (R) d'adaptation à la ligne et connectée à celle-ci,
- un premier générateur (G1) commandé en réponse auxdits signaux de commande d'émission (e, e*) et comportant une source de courant (S1) réglable pour fournir un courant à ladite première impédance (R) et à ladite ligne (L, L*), alimentées en parallèle,
- des moyens de détection (G2, r) commandés en réponse auxdits signaux de commande d'émission (e, e*) pour fournir un signal de mesure (V) qui est représentatif soit du courant circulant dans l'impédance d'adaptation (R) lorsque ledit premier générateur (G1) est actif, soit de la somme du courant circulant dans l'impédance d'adaptation (R) et d'une valeur de compensation lorsque ledit premier générateur (G1) n'est pas actif,

ladite valeur de compensation étant déterminée de façon à satisfaire à une condition de compensation selon laquelle ledit signal de mesure (V) ne dépend pratiquement que des signaux d'émission produits par l'autre émetteur-récepteur, et en ce que:

- des premiers moyens d'asservissement (2) communs à plusieurs des dits émetteurs-récepteurs commandent ladite source de courant (S1) de façon à satisfaire ladite condition de compensation,
- des seconds moyens d'asservissement (3) communs à plusieurs des dits émetteurs-récepteurs commandent la première impédance (R) de façon à lui faire prendre une valeur égale à celle d'une impédance calibrée (Rc) extérieure au circuit intégré et ayant la valeur de l'impédance caractéristique de la ligne.

17. Circuit intégré selon la revendication 16, caractérisé en ce que lesdits moyens de détection comportent une seconde impédance (r) dont une première borne est reliée à un point commun (U) à l'impédance d'adaptation et à la ligne, et un second générateur (G2) commandé en réponse aux signaux de commande d'émission et de même polarité que ledit premier générateur (G1) pour alimenter en courant la seconde borne (V) de la seconde impédance (r), appelée borne de réception, en ce que lesdits premier et second générateurs (G1, G2) sont commandés en réponse auxdits signaux de commande d'émission (e, e*) de façon à ce que le premier générateur (G1) soit actif alors que le second générateur (G2) ne l'est pas et réciproquement et en ce que ledit signal de mesure est la tension présente sur ladite borne de réception (V), ladite valeur de compensation étant la tension aux bornes de ladite seconde impédance (r), lesdits générateurs (G1, G2) et ladite seconde impédance (r) étant dimensionnés de façon à satisfaire ladite condition de compensation.

18. Système informatique comportant des unités fonctionnelles communiquant entre elles, caractérisé en ce que certaines desdites unités comportent au moins un circuit intégré comportant une pluralité d'émetteurs-récepteurs prévus chacun pour être relié par une liaison de transmission à un autre émetteur-récepteur analogue du circuit intégré appartenant à une autre unité fonctionnelle du système, ladite liaison comportant au moins une ligne de transmission (L, L*), chaque émetteur-récepteur comportant des moyens d'amplification pour produire des signaux d'émission sur ladite liaison en réponse à des signaux de commande d'émission (e, e*) et pour produire des signaux de réception (s, s*) en réponse aux signaux d'émission produits sur ladite liaison par l'autre émetteur-récepteur, lesdits moyens d'amplification comportant pour chaque ligne de transmission (L, L*) un amplificateur bidirectionnel (1) comprenant:

- une première impédance réglable (R) d'adaptation à la ligne et connectée à celle-ci,
- un premier générateur (G1) commandé en réponse auxdits signaux de commande d'émission (e, e*) et comportant une source de courant (S1) réglable pour fournir un courant à ladite première impédance (R) et à ladite ligne (L, L*), alimentées en parallèle,
- des moyens de détection (G2, r) commandés en réponse auxdits signaux de commande d'émission (e, e*) pour fournir un signal de mesure (V) qui est représentatif soit du courant circulant dans l'impédance d'adaptation (R) lorsque ledit premier générateur (G1) est actif, soit de la somme du courant circulant dans l'impédance d'adaptation (R) et d'une valeur de compensation lorsque ledit premier générateur (G1) n'est pas actif,

ladite valeur de compensation étant déterminée de façon à satisfaire à une condition de compensation selon laquelle ledit signal de mesure (V) ne dépend pratiquement que des signaux d'émission produits par l'autre émetteur-récepteur, et en ce que:

- des premiers moyens d'asservissement (2) communs à plusieurs des dits émetteurs-récepteurs commandent ladite source de courant (S1) de façon à satisfaire ladite condition de compensation,
- des seconds moyens d'asservissement (3) communs à plusieurs des dits émetteurs-récepteurs commandent la première impédance (R) de façon à lui faire prendre une valeur égale à celle d'une impédance calibrée (Rc) extérieure au circuit intégré et ayant la valeur de l'impédance caractéristique de la ligne.

**Patentansprüche**

1. Sender-Empfänger, der dazu vorgesehen ist, über eine Übertragungsverbindung mit einem anderen, ähnlichen Sender-Empfänger verbunden zu werden, wobei die Verbindung wenigstens eine Übertragungsleitung (L, L*) enthält, wobei der Sender-Empfänger Verstärkungsmittel enthält, um auf der Verbindung als Antwort auf Sendebefehlssignale (e, e*) Sendesignale zu erzeugen und um als Antwort auf Sendesignale, die vom anderen Sender-Empfänger auf der Verbindung erzeugt werden, Empfangssignale (s, s*) zu erzeugen, wobei die Verstärkungsmittel für jede Übertragungsleitung (L, L*) einen bidirektionalen Verstärker (1) enthalten, der eine erste Impedanz (R) für die Anpassung an die Leitung enthält, die an diese angeschlossen ist, wobei der Sender-Empfänger dadurch gekennzeichnet ist, daß der bidirektionale Verstärker enthält:

- einen ersten Generator (G1), der als Antwort auf die Sendebefehlssignale (e, e*) gesteuert wird, um zur ersten Impedanz (R) und zur Leitung (L, L*), die parallel gespeist werden, einen Strom zu liefern,
- Erfassungsmittel (G2, r), die als Antwort auf die Sendebefehlssignale (e, e*) gesteuert werden, um ein Meßsignal (V) zu liefern, das entweder den durch die Anpassungsimpedanz (R) fließenden Strom bei aktivem ersten Generator (G1) oder die Summe aus dem durch die Anpassungsimpedanz (R) fließenden Strom und aus einem Kompensationswert bei nicht aktivem ersten Generator (G1) repräsentiert,

wobei der Kompensationswert in der Weise bestimmt wird, daß er eine Kompensationsbedingung erfüllt, gemäß der das Meßsignal (V) im wesentlichen nur von Sendesignalen abhängt, die vom anderen Sender-Empfänger erzeugt werden.

2.  Sender-Empfänger nach Anspruch 1, dadurch gekennzeichnet, daß die Erfassungsmittel eine zweite Impedanz (r), wovon ein erster Anschluß mit einem gemeinsamen Punkt (U) der Anpassungsimpedanz und der Leitung verbunden ist, sowie einen zweiten Generator (G2) enthalten, der als Antwort auf die Sendebefehlssignale gesteuert wird und die gleiche Polarität wie der erste Generator (G1) besitzt, um den zweiten Anschluß (V) der zweiten Impedanz (r), der Empfangsanschluß genannt wird, mit Strom zu versorgen, daß der erste und der zweite Generator (G1, G2) als Antwort auf die Sendebefehlssignale (e, e*) in der Weise gesteuert werden, daß der erste Generator (G1) aktiv ist, während der zweite Generator (G2) nicht aktiv ist, und umgekehrt, und daß das Meßsignal die am Empfangsanschluß (V) anliegende Spannung ist, wobei der Kompensationswert die Spannung über den Anschlüssen der zweiten Impedanz (r) ist, wobei die Generatoren (G1, G2) und die zweite Impedanz (r) so dimensioniert sind, daß sie die Kompensationsbedingung erfüllen.

3.  Sender-Empfänger nach Anspruch 2, dadurch gekennzeichnet, daß der erste Generator (G1) eine einstellbare Stromquelle (S1) enthält, die durch erste Regelungsmittel (2) gesteuert wird, derart, daß die Kompensationsbedingung erfüllt wird.

4.  Sender-Empfänger nach Anspruch 3, dadurch gekennzeichnet, daß er einen Teil einer integrierten Schaltung bildet und daß die erste Impedanz (R) einstellbar ist und durch zweite Regelungsmittel (3) gesteuert wird, derart, daß die erste Impedanz (R) einen Wert annimmt, der gleich demjenigen einer kalibrierten Impedanz (Rc) ist, die sich außerhalb der integrierten Schaltung befindet und den Wert der charakteristischen Impedanz der Leitung besitzt.

5.  Sender-Empfänger nach Anspruch 4, dadurch gekennzeichnet, daß die erste Impedanz (R) unter der Steuerung eines Prüfsignals (INF) in den Zustand hoher Impedanz versetzt werden kann.

6.  Sender-Empfänger nach Anspruch 4 oder 5, dadurch gekennzeichnet, daß die erste einstellbare Impedanz (R) mit Feldeffekttransistoren (P0-P6) verwirklicht ist, deren Drain-Source-Pfade parallelgeschaltet sind und durch die zweiten Regelungsmittel (3) wahlweise in den leitenden Zustand versetzt werden.

7.  Sender-Empfänger nach einem der Ansprüche 3 bis 6, dadurch gekennzeichnet, daß der Strom (I) der Stromquelle (S1) vom Kollektor eines Bipolartransistors (T3) geliefert wird, dessen Emitter über einen Widerstand (N1) mit einem zweiten Potential (Vss) verbunden ist, und daß die ersten Regelungsmittel (2) die Basisspannung des Bipolartransistors (3) steuern.

8.  Sender-Empfänger nach Anspruch 7, dadurch gekennzeichnet, daß der Widerstand (N1) durch den Drain-Source-Pfad eines Feldeffekttransistors gebildet ist, dessen Gate durch ein Einschaltsignal (AUTO) der Verstärkungsmittel vorgespannt wird.

9.  Sender-Empfänger nach einem der Ansprüche 2 bis 6, dadurch gekennzeichnet, daß die Verstärkungsmittel dann, wenn die Verbindung zwei Übertragungsleitungen (L, L*) enthält, zwei Kanäle enthalten, die aus zwei bidirektionalen Verstärkern (1) gebildet sind, die den Übertragungsleitungen entsprechend zugeordnet sind, daß die bidirektionalen Verstärker entsprechend durch zwei differentielle Sendebefehlssignale (e, e*) gesteuert werden, daß eines der differentiellen Sendebefehlssignale (e) den ersten Generator (G1) des ersten Verstärkers sowie den zweiten Generator (G2*) des zweiten Verstärkers steuert, während das andere der differentiellen Sendebefehlssignale (e*) den ersten Generator (G1*) des zweiten bidirektionalen Verstärkers sowie den zweiten Generator (G2) des ersten bidirektionalen Verstärkers steuert, und daß die Empfangssignale (s, s*) von der differentiellen Spannung (V, V*) abhängen, die zwischen den Empfangsanschlüssen der bidirektionalen Verstärker anliegt.

10. Sender-Empfänger nach Anspruch 9, dadurch gekennzeichnet, daß die ersten Generatoren (G1, G1*) Stromgeneratoren sind und eine erste gemeinsame Stromquelle (S1) enthalten, daß jeder erste Stromgenerator (G1, G1*) einen ersten Ein/Aus-Schalter (T1, T1*) enthält, der die erste gemeinsame Stromquelle (S1) mit dem ersten Anschluß (U) der zweiten Impedanz (r) verbindet, und daß die ersten Ein/Aus-Schalter (T1, T1*) durch die entsprechenden differentiellen Sendebefehlssignale (e, e*) gesteuert werden.

11. Sender-Empfänger nach Anspruch 10, dadurch gekennzeichnet, daß die zweiten Generatoren (G2, G2*) Stromgeneratoren sind und eine gemeinsame Stromquelle (S2) enthalten, daß jeder der zweiten Stromgeneratoren einen zweiten Ein/Aus-Schalter (T2, T2*) enthält, der die zweite gemeinsame Stromquelle (S2) mit dem Empfangsanschluß (V) verbindet, und daß der zweite Ein/Aus-Schalter (T2, T2*), der einer Übertragungsleitung (L, L*) zugeordnet ist, durch das differentielle Sendebefehlssignal (e*, e) gesteuert wird, das den ersten Ein/Aus-Schalter (T1, T1*) steuert, der der anderen Übertragungsleitung (L, L*) zugeordnet ist.

12. Sender-Empfänger nach Anspruch 11, dadurch gekennzeichnet, daß die erste gemeinsame Stromquelle (S1) einstellbar ist und durch die ersten Regelungsmittel (2) gesteuert wird, die eine Regelungsschaltung (9) enthalten, die aus zwei bidirektionalen Verstärkern gebildet ist, wobei jeder bidirektionale Verstärker eine erste Impedanz (Ra, Ra*), einen ersten Generator (G1), der als Antwort auf die Sendebefehlssignale (e, e*) gesteuert wird, um einen Strom zur ersten Impedanz (Ra, Ra*) zu liefern, und Erfassungsmittel (G2, r) enthält, die ein Meßsignal (V) liefern, das entweder den durch die Impedanz (Ra, Ra*) fließenden Strom bei aktivem ersten Generator (G1) oder die Summe aus dem durch die Impedanz (Ra, Ra*) fließenden Strom und aus einem Kompensationswert bei nicht aktivem ersten Generator (G1) repräsentiert, wobei die Erfassungsmittel eine zweite Impedanz (z) enthalten, wovon ein erster Anschluß mit einem gemeinsamen Punkt (U) der Impedanz (Ra, Ra*) und des Generators (G1) verbunden ist und wovon der zweite Anschluß (V) durch einen gesteuerten zweiten Generator (G2) mit der gleichen Polarität wie der erste Generator (G1) gespeist wird, wobei der erste und der zweite Generator (G1, G2) als Antwort auf die Sendebefehlssignale (e, e*) in der Weise gesteuert werden, daß der erste Generator (G1) aktiv ist, während der zweite Generator (G2) nicht aktiv ist, und umgekehrt, wobei das Meßsignal die Spannung ist, die am Empfangsanschluß (V) anliegt, wobei der Kompensationswert die Spannung über den Anschlüssen der zweiten Impedanz (r) ist, wobei die Generatoren (G1, G2) und die zweite Impedanz (r) so dimensioniert sind, daß sie die Kompensationsbedingung erfüllen, wobei die bidirektionalen Verstärker entsprechend durch zwei differentielle Sendebefehlssignale (e, e*) gesteuert werden, derart, daß eines der differentiellen Sendebefehlssignale (e) den ersten Generator (G1) des ersten Verstärkers sowie den zweiten Generator (G2*) des zweiten Verstärkers steuert, während das andere der differentiellen Sendebefehlssignale (e*) den ersten Generator (G1*) des zweiten bidirektionalen Verstärkers sowie den zweiten Generator (G2) des ersten bidirektionalen Verstärkers steuert, wobei die Regelungsschaltung so dimensioniert und vorgespannt ist, daß sie auf einem Kanal eine Sendung und auf dem anderen Kanal das Fehlen einer Sendung simuliert, und daß die ersten Regelungsmittel (2) außerdem einen Spannungskomparator (10) enthalten, dessen Eingänge entsprechend mit den Empfangsanschlüssen (V, V*) der Verstärker der Regelungsschaltung verbunden sind und dessen Ausgang die ersten Stromquellen (S1) der Regelungsschaltung (9) und der bidirektionalen Verstärker (1) steuert.

13. Sender-Empfänger nach Anspruch 12, dadurch gekennzeichnet, daß die ersten und zweiten Ein/Aus-Schalter (T1, T1*, T2, T2*) Bipolartransistoren sind, deren Emitter-Kollektor-Pfade die erste bzw. die zweite gemeinsame Stromquelle (S1, S2) mit dem ersten Anschluß (U) der zweiten Impedanz (r) bzw. mit dem Empfangsanschluß (V, V*) des bidirektionalen Verstärkers (1) verbinden.

14. Sender-Empfänger nach Anspruch 13, dadurch gekennzeichnet, daß die erste gemeinsame Stromquelle (S1) einen dritten Bipolartransistor (T3) enthält, dessen Emitter über einen ersten Widerstand (N1) mit einem zweiten Potential (Vss) verbunden ist und dessen Kollektor mit den Emittern der ersten Bipolartransistoren (T1, T1*) verbunden ist, und daß die Basis des dritten Transistors (T3) mit dem Ausgang des Komparators (10) der ersten Regelungsmittel (2) verbunden ist.

15. Sender-Empfänger nach Anspruch 14, dadurch gekennzeichnet, daß die zweite gemeinsame Stromquelle (S2) einen vierten Bipolartransistor (T4) enthält, dessen Emitter über einen zweiten Widerstand (N2) mit dem zweiten Potential (Vss) verbunden ist und dessen Kollektor mit den Emittern der zweiten Bipolartransistoren (T2, T2*) verbunden ist, und daß die Basis des vierten Transistors (T4) in der Weise vorgespannt (Vref) ist, daß der Wert des Produkts R · I fest ist, wobei R der Wert der ersten Impedanz ist und I der Wert des von der zweiten gemeinsamen Stromquelle (S2) gelieferten Stroms ist.

16. Integrierte Schaltung, die mehrere Sender-Empfänger enthält, die jeweils dazu vorgesehen sind, über eine Übertragungsverbindung mit einem anderen, ähnlichen Sender-Empfänger verbunden zu werden, wobei die Verbindung wenigstens eine Übertragungsleitung (L, L*) enthält, wobei jeder Sender-Empfänger Verstärkungsmittel enthält, um auf der Verbindung als Antwort auf Sendebefehlssignale (e, e*) Sendesignale zu erzeugen und um als Antwort auf Sendesignale, die auf der Verbindung durch den anderen Sender-Empfänger erzeugt werden, Empfangssignale (s, s*) zu erzeugen,
wobei die integrierte Schaltung dadurch gekennzeichnet ist, daß:
die Verstärkungsmittel für jede Übertragungsleitung (L, L*) einen bidirektionalen Verstärker (1) enthalten, der seinerseits versehen ist mit:

- einer ersten einstellbaren Impedanz (R) für die Anpassung an die Leitung, die mit dieser verbunden ist,
- einem ersten Generator (G1), der als Antwort auf die Sendebefehlssignale (e, e*) gesteuert wird und eine einstellbare Stromquelle (S1) enthält, um zur ersten Impedanz (R) und zur Leitung (L, L*), die parallel gespeist werden, einen Strom zu liefern,
- Erfassungsmitteln (G2, r), die als Antwort auf die Sendebefehlssignale (e, e*) gesteuert werden, um ein Meßsignal (V) zu liefern, das entweder den durch die Anpassungsimpedanz (R) fließenden Strom bei aktivem ersten Generator (G1) oder die Summe aus dem durch die Anpassungsimpedanz (R) fließenden Strom und aus einem Kompensationswert bei nicht aktivem ersten Generator (G1) repräsentiert,

wobei der Kompensationswert in der Weise bestimmt wird, daß er eine Kompensationsbedingung erfüllt, gemäß der das Meßsignal (V) im wesentlichen nur von den vom anderen Sender-Empfänger erzeugten Sendesignalen abhängt,
und dadurch, daß:

- erste Regelungsmittel (2), die mehreren der Sender-Empfänger gemeinsam sind, die Stromquelle (S1) so steuern, daß die Kompensationsbedingung erfüllt ist,
- zweite Regelungsmittel (3), die mehreren der Sender-Empfänger gemeinsam sind, die erste Impedanz (R) so steuern, daß sie einen Wert annimmt, die gleich demjenigen einer kalibrierten Impedanz (Rc) ist, die sich außerhalb der integrierten Schaltung befindet und den Wert der charakteristischen Impedanz der Leitung besitzt.

17. Integrierte Schaltung nach Anspruch 16, dadurch gekennzeichnet, daß die Erfassungsmittel eine zweite Impedanz (r), wovon ein erster Anschluß mit einem gemeinsamen Punkt (U) der Anpassungsimpedanz und der Leitung verbunden ist, sowie einen zweiten Generator (G2) enthalten, der als Antwort auf die Sendebefehlssignale gesteuert wird und die gleiche Polarität wie der erste Generator (G1) besitzt, um den zweiten Anschluß (V) der zweiten Impedanz (r), der Empfangsanschluß genannt wird, mit Strom zu versorgen, daß der erste und der zweite Generator (G1, G2) als Antwort auf die Sendebefehlssignale (e, e*) in der Weise gesteuert werden, daß der erste Generator (G1) aktiv ist, während der zweite Generator (G2) nicht aktiv ist, und umgekehrt, und daß das Meßsignal die Spannung ist, die am Empfanganschluß (V) anliegt, wobei der Kompensationswert die Spannung über den Anschlüssen der zweiten Impedanz (r) ist, wobei die Generatoren (G1, G2) und die zweite Impedanz (r) so dimensioniert sind, daß sie die Kompensationsbedingung erfüllen.

18. Datenverarbeitungssystem, das funktionale Einheiten enthält, die untereinander Informationen austauschen, dadurch gekennzeichnet, daß bestimmte dieser Einheiten wenigstens eine integrierte Schaltung enthalten, die mehrere Sender-Empfänger enthält, die jeweils dazu vorgesehen sind, über eine Übertragungsverbindung mit einem anderen, ähnlichen Sender-Empfänger der integrierten Schaltung, der zu einer anderen funktionalen Einheit des Systems gehört, verbunden zu werden, wobei die Verbindung wenigstens eine Übertragungsleitung (L, L*) enthält, wobei jeder Sender-Empfänger Verstärkungsmittel enthält, um auf der Verbindung als Antwort auf Sendebefehlssignale (e, e*) Sendesignale zu erzeugen und um als Antwort auf Sendesignale, die auf der Verbindung vom anderen Sender-Empfänger erzeugt werden, Empfangssignale (s, s*) zu erzeugen, wobei die Verstärkungsmittel für jede Übertragungsleitung (L, L*) einen bidirektionalen Verstärker (1) enthalten, der seinerseits enthält:

- eine erste einstellbare Impedanz (R) für die Anpassung an die Leitung, die mit dieser verbunden ist,
- einen ersten Generator (G1), der als Antwort auf die Sendebefehlssignale (e, e*) gesteuert wird und eine einstellbare Stromquelle (S1) enthält, um zur ersten Impedanz (R) und zur Leitung (L, L*), die parallel gespeist werden, einen Strom zu liefern,

- Erfassungsmittel (G2, r), die als Antwort auf die Sendebefehlssignale (e, e*) gesteuert werden, um ein Meßsignal (V) zu liefern, das entweder den durch die Anpassungsimpedanz (R) fließenden Strom bei aktivem erstem Generator (G1) oder die Summe aus dem durch die Anpassungsimpedanz (R) fließenden Strom und aus einem Kompensationswert bei nicht aktivem erstem Generator (G1) repräsentiert,

wobei der Kompensationswert in der Weise bestimmt wird, daß er eine Kompensationsbedingung erfüllt, gemäß der das Meßsignal (V) im wesentlichen nur von den vom anderen Sender-Empfänger erzeugten Sendesignalen abhängt,
und dadurch, daß:

- erste Regelungsmittel (2), die mehreren der Sender-Empfänger gemeinsam sind, die Stromquelle (S1) so steuern, daß die Kompensationsbedingung erfüllt ist,
- zweite Regelungsmittel (3), die mehreren der Sender-Empfänger gemeinsam sind, die erste Impedanz (R) so steuern, daß sie einen Wert annimmt, der gleich demjenigen einer kalibrierten Impedanz (Rc) ist, die sich außerhalb der integrierten Schaltung befindet und den Wert der charakteristischen Impedanz der Leitung besitzt.

## Claims

1. Transceiver intended to be connected by a transmission link to another similar transceiver, said link comprising at least one transmission line (L, L*), said transceiver comprising amplification means for producing transmission signals over said link in response to transmission-control signals (e, e*) and for producing reception signals (s, s*) in response to the transmission signals produced over said link by the other transceiver, said amplification means comprising, for each transmission line (L, L*), a bidirectional amplifier (1) comprising a first impedance (R) for matching the line and connected thereto, said transceiver being characterised in that said bidirectional amplifier comprises:

   - a first generator (G1) controlled in response to said transmission-control signals (e, e*) in order to supply a current to said first impedance (R) and to said line (L, L*), supplied with power in parallel,
   - detection means (G2, r) controlled in response to said transmission-control signals (e, e*) in order to supply a measurement signal (V) that is representative either of the current flowing through the matching impedance (R) when said first generator (G1) is active, or of the sum of the current flowing through the matching impedance (R) and a compensation value when said first generator (G1) is inactive,

   said compensation value being determined so as to satisfy a compensation condition according to which said measurement signal (V) depends in practice only on the transmission signals produced by the other transceiver.

2. A transceiver according to Claim 1 characterised in that said detection means comprise a second impedance (r), a first terminal of which is connected to a point (U) common to the matching impedance and the line, and a second generator (G2) controlled in response to the transmission-control signals and of the same polarity as said first generator (G1) in order to supply current to the second terminal (V) of the second impedance (r), known as the reception terminal, in that said first and second generators (G1, G2) are controlled in response to said transmission-control signals (e, e*) such that the first generator (G1) is active while the second generator (G2) is inactive and vice versa, and in that said measurement signal is the voltage present at said reception terminal (V), said compensation value being the voltage at the terminals of said second impedance (r), said generators (G1, G2) and said second impedance (r) being dimensioned so as to satisfy their compensation condition.

3. A transceiver according to Claim 2, characterised in that said first generator (G1) comprises a current source (S1) adjustable and controlled by first servo-control means (2) such that said compensation condition is satisfied.

4. A transceiver according to Claim 3, characterised in that it forms part of an integrated circuit and in that the first impedance (R) is adjustable and controlled by second servo-control means (3) such that said first impedance (R) takes a value equal to that of a calibrated impedance (Rc) outside the integrated circuit and having the value of the characteristic impedance of the line.

5. A transceiver according to Claim 4, characterised in that, under the control of a test signal (INF), said first impedance (R) can be put into the state of high impedance.

**6.** A transceiver according to Claim 4 or 5, characterised in that said first adjustable impedance (R) is produced by means of field-effect transistors (PO - P6), the drain-source paths of which are connected in parallel and made selectively conducting by said second servo-control means (3).

**7.** A transceiver according to one of Claims 3 to 6, characterised in that the current (I) of said current source (S1) is supplied by the collector of a bipolar transistor (T3), the emitter of which is connected to a second potential (Vss) via a resistor (N1) and in that said first servo-control means (2) control the base voltage of said bipolar transistor (3).

**8.** A transceiver according to Claim 7, characterised in that said resistor (N1) is constituted by the drain-source path of a field-effect transistor, the gate of which is polarised by a signal (AUTO) indicating that power has been supplied to said amplification means.

**9.** A transceiver according to one of Claims 2 to 6 characterised in that, said link comprising two transmission lines (L, L*), said amplification means comprise two channels formed of two bidirectional amplifiers (1) associated respectively with said transmission lines, in that said bidirectional amplifiers are controlled respectively by two differential transmission-control signals (e, e*), in that one of the differential transmission-control signals (e) controls the first generator (G1) of the first amplifier and also the second generator (G2*) of the second amplifier, the other one of said differential transmission-control signals (e*) controls the first generator (G1*) of the second bidirectional amplifier and also the second generator (G2) of the first bidirectional amplifier and in that said reception signals (s, s*) are a function of the differential voltage (V, V*) present between the reception terminals of the two bidirectional amplifiers.

**10.** A transceiver according to Claim 9, characterised in that said first generators (G1, G1*) are current generators and comprise a first common current source (S1), in that each first current generator (G1, G1*) comprises a first switch (T1, T1*) connecting said first common current source (S1) to said first terminal (U) of the second impedance (r) and in that said first switches (T1, T1*) are controlled respectively by said differential transmission-control signals (e, e*).

**11.** A transceiver according to Claim 10, characterised in that said second generators (G2, G2*) are current generators and comprise a common current source (S2), and in that each of said second current generators comprises a second switch (T2, T2*) connecting said second common current source (S2) to said reception terminal (V) and in that the second switch (T2, T2*), which is associated with a transmission line (L, L*) is controlled by the differential transmission-control signal (e*, e) that controls the first switch (T1, T1*) associated with the other transmission line (L, L*).

**12.** A transceiver according to Claim 11, characterised in that said first common current source (S1) is adjustable and controlled by first servo-control means (2), which comprise a servo-control circuit (9) constituted by two bidirectional amplifiers, each bidirectional amplifier comprising a first impedance (Ra, Ra*), a first generator (G1) controlled in response to transmission-control signals (e, e*) so as to supply a current to said first impedance (Ra, Ra*), detection means (G2, r) to supply a measurement signal (V) that is representative either of the current flowing through the impedance (Ra, Ra*) when said first generator (G1) is active, or of the sum of the current flowing through the impedance (Ra, Ra*) and of a compensation value when said first generator (G1) is inactive, said detection means comprising a second impedance (z), a first terminal of which is connected to a point (U) common to the impedance (Ra, Ra*) and to said generator (G1), the second terminal (V) of which is supplied with power by a second generator (G2) controlled and of the same polarity as said first generator (G1), said first and second generators (G1, G2) being controlled in response to said transmission-control signals (e, e*) such that the first generator (G1) is active while the second generator (G2) is inactive and vice versa, said measurement signal being the voltage present at said reception terminal (V), said compensation value being the voltage at the terminals of said second impedance (r), said generators (G1, G2) and said second impedance (r) being dimensioned so as to satisfy their compensation condition, said bidirectional amplifiers being controlled respectively by two differential transmission-control signals (e, e*), such that one of the differential transmission-control signals (e) controls the first generator (G1) of the first amplifier and also the second generator (G2*) of the second amplifier, the other one of said differential transmission-control signals (e*) controls the first generator (G1*) of the second bidirectional amplifier and also the second generator (G2) of the first bidirectional amplifier, said servo-control circuit being dimensioned and polarised so as to simulate a transmission over one channel and the absence of transmission over the other channel and in that said first servo-control means (2) further comprise a voltage comparator (10), the inputs of which are connected respectively to the reception terminals (V, V*) of the amplifiers of said servo-control circuit and the output of which controls the first current sources (S1) of said servo-control circuit (9) and of said bidirectional amplifiers (1).

13. A transceiver according to Claim 12, characterised in that said first and second switches (T1, T *, T2, T2*) are bipolar transistors, the emitter-collector paths of which connect respectively the first and second common current source (S1, S2) to, respectively, said first terminal (U) of the second impedance (r) and said reception terminal (V, V*) of said bidirectional amplifier (1).

14. A transceiver according to Claim 13, characterised in that said first common current source (S1) comprises a third bipolar transistor (T3), the emitter of which is connected to a second potential (Vss) via a first resistor (N1) and the collector of which is connected to the emitters of the first bipolar transistors (T1, T1 *) and in that the base of said third transistor (T3) is connected to the output of the comparator (1 0) of said first servo-control means (2).

15. A transceiver according to Claim 14 characterised in that said second common current source (S2) comprises a fourth bipolar transistor (T4), the emitter of which is connected to the second potential (Vss) via a second resistor (N2) and the collector of which is connected to the emitters of the second bipolar transistors (T2, T2*) and in that the base of said fourth transistor (T4) is polarised (Vref) so as to fix the value of the product R.I, where R is the value of the first impedance and I is the value of the current supplied by the second common current source (S2).

16. An integrated circuit, comprising a plurality of transceivers each intended to be connected by a transmission link to another similar transceiver, said link comprising at least one transmission line (L, L*), each transceiver comprising amplification means for producing transmission signals over said link in response to transmission-control signals (e, e*) and for producing reception signals (s, s*) in response to the transmission signals produced over said link by the other transceiver,
said integrated circuit being characterised in that:
said amplification means comprise, for each transmission line (L, L*), a bidirectional amplifier (1) comprising:

- a first adjustable impedance (R) for matching the line and connected thereto,
- a first generator (G1) controlled in response to said transmission-control signals (e, e*) and comprising an adjustable current source (S1) for supplying a current to said first impedance (R) and to said line (L, L*), supplied with power in parallel,
- detection means (G2, r) controlled in response to said transmission-control signals (e, e*) in order to supply a measurement signal (V) which is representative either of the current flowing through the matching impedance (R) when said first generator (G1) is active, or of the sum of the current flowing through the matching impedance (R) and a compensation value when said first generator (G1) is inactive,

said compensation value being determined so as to satisfy a compensation condition according to which said measurement signal (V) depends in practice only on the transmission signals produced by the other transceiver, and in that:

- first servo-control means (2) common to several of said transceivers control said current source (S1) so as to satisfy said compensation condition,
- second servo-control means (3) common to several of said transceivers control the first impedance (R) so as to cause it to take a value equal to that of a calibrated impedance (Rc) external to the integrated circuit and having the characteristic impedance value of the line.

17. An integrated circuit according to Claim 16, characterised in that said detection means comprise a second impedance (r), a first terminal of which is connected to a point (U) common to the matching impedance and the line, and a second generator (G2) controlled in response to the transmission-control signals and of the same polarity as said first generator (G1) in order to supply current to the second terminal (V) of the second impedance (r), known as the reception terminal, in that said first and second generators (G1, G2) are controlled in response to said transmission-control signals (e, e*) such that the first generator (G1) is active while the second generator (G2) is inactive and vice versa, and in that said measurement signal is the voltage present at said reception terminal (V), said compensation value being the voltage at the terminals of said second impedance (r), said generators (G1, G2) and said second impedance (r) being dimensioned so as to satisfy their compensation condition.

18. An information processing system comprising intercommunicating functional units, characterised in that some of said units comprise at least one integrated circuit comprising a plurality of transceivers each intended to be connected by a transmission link to another similar transceiver of the integrated circuit belonging to another functional unit of the system, said link comprising at least one transmission line (L, L*), each transceiver comprising amplification means for producing transmission signals over said link in response to transmission-control signals (e, e*) and for producing reception signals (s, s*) in response to the transmission signals produced over said link by the other transceiver, said amplification means comprising, for each transmission line (L, L*), a bidirectional amplifier (1) comprising:

- a first adjustable impedance (R) for matching the line and connected thereto,
- a first generator (G1) controlled in response to said transmission-control signals (e, e*) and comprising an adjustable current source (S1) for supplying a current to said first impedance (R) and to said line (L, L*), supplied with power in parallel,
- detection means (G2, r) controlled in response to said transmission-control signals (e, e*) in order to supply a measurement signal (V) which is representative either of the current flowing through the matching impedance (R) when said first generator (G1) is active, or of the sum of the current flowing through the matching impedance (R) and a compensation value when said first generator (G1) is inactive,

said compensation value being determined so as to satisfy a compensation condition according to which said measurement signal (V) depends in practice only on the transmission signals produced by the other transceiver, and in that:

- first servo-control means (2) common to several of said transceivers control said current source (S1) so as to satisfy said compensation condition,
- second servo-control means (3) common to several of said transceivers control the first impedance (R) so as to cause it to take a value equal to that of a calibrated impedance (Rc) external to the integrated circuit and having the characteristic impedance value of the line.

FIG. 1

FIG. 2

# FIG. 3

FIG. 4

FIG. 5

FIG. 6

FIG. 7

FIG. 8

FIG. 9

FIG. 10

FIG. 11

FIG. 12